# EUROPEAN PATENT APPLICATION

(11) **EP 3 828 901 A1**
(43) Date of publication of application: **02.06.2021**
(21) Application number: 19841929.3
(22) Date of filing: 24.07.2019
(51) Int. Cl.: H01F 1/37, H01F 1/34, H01F 17/04, H05K 1/16

(54) **MAGNETIC PASTE**

(30) Priority: 25.07.2018 JP 2018139537; 22.11.2018 JP 2018219667; 12.03.2019 JP 2019044785; 28.06.2019 WO PCT/JP2019/025926
(71) Applicant: AJINOMOTO CO., INC., Chuo-ku Tokyo 104-8315 (JP)
(72) Inventor: HOMMA, Tatsuya, Kawasaki-shi, Kanagawa 210-0801 (JP); OURA, Ichiro, Kawasaki-shi, Kanagawa 210-0801 (JP); YODA, Masanori, Kawasaki-shi, Kanagawa 210-0801 (JP); TANAKA, Takayuki, Kawasaki-shi, Kanagawa 210-0801 (JP); OOYAMA, Hideki, Kawasaki-shi, Kanagawa 210-0801 (JP); HAGIWARA, Chihiro, Kawasaki-shi, Kanagawa 210-0801 (JP)
(74) Representative: Mewburn Ellis LLP
(86) International application number: PCT/JP2019/029074
(87) International publication number: WO 2020/022393

(57) **Abstract**

Provided are a magnetic paste capable of achieving a cured product having a low viscosity and being excellent in mechanical strength and adhesion strength, and the cured product, a circuit board, and an inductor component in each of which the magnetic paste is used.

## Description

### Field

The present invention relates to a magnetic paste, and a cured product, a circuit board, and an inductor component in each of which the magnetic paste is used.

### Background

In recent years, with demands for downsizing and slimming down of electronic devices, downsizing of a circuit board to be used for electronic devices and high densification of wirings in the circuit board have been required. As such circuit board, there is known a circuit board formed by filling a through hole with a paste material.

For example, Patent Literature 1 describes a filling resin containing magnetic substance particles, such as ferric oxide (III) or cobalt ferrite, as a resin with which a through hole in a circuit board for inductor components is filled.

### Citation List

### Patent Literature

Patent Literature 1: Japanese Patent Application Laid-open No. 2016-197624

### Summary

### Technical Problem

In order to enhance the relative magnetic permeability of a cured product of a magnetic paste like a filling resin described in Patent Literature 1, a method by which a filling resin contains magnetic powder can be used. However, when a magnetic paste contains magnetic powder, the magnetic paste has higher viscosity, and accordingly the magnetic paste sometimes has lower printability. Furthermore, when a magnetic paste contains magnetic powder, a cured product of the magnetic paste sometimes has lower mechanical strength and lower plating adhesion strength. In particular, the use of a paste containing magnetic powder in large amounts, like the filling resin described in Patent Literature 1, causes lower viscosity, lower mechanical strength, and lower adhesion strength.

The present invention has been made in view of the circumstances described above, and an object of the present invention is to provide a magnetic paste having low viscosity even when containing magnetic powder and capable of achieving a cured product excellent in mechanical strength and adhesion strength, and the cured product, a circuit board, and an inductor component in each of which the magnetic paste is used.

### Solution to Problem

To achieve the above-described object, the inventors carried out intensive studies, and found that the use of a magnetic paste containing an acidic dispersant allows a cured product having low viscosity and excellent in mechanical strength and adhesion strength to be obtained, and thus the present invention was completed.
[1] A magnetic paste, comprising:
   magnetic powder (A);
   an epoxy resin (B);
   an acidic dispersant (C); and
   a curing agent (D).
[2] The magnetic paste according to [1], wherein the acidic dispersant (C) has a pH of less than 4.
[3] The magnetic paste according to [1] or [2], wherein the acidic dispersant (C) has a pH of 2 or more.
[4] The magnetic paste according to any one of [1] to [3], wherein a content of the acidic dispersant (C) is 0.1% by mass or higher and 5% by mass or lower, with respect to 100% by mass of non-volatile components in the magnetic paste.
[5] The magnetic paste according to any one of [1] to [4], wherein the curing agent (D) includes an imidazole-based epoxy resin curing agent.
[6] The magnetic paste according to any one of [1] to [5], wherein the magnetic powder (A) is at least one selected from iron oxide powder and iron alloy-based metal powder.
[7] The magnetic paste according to any one of [1] to [6], wherein
   the magnetic powder (A) includes iron oxide powder, and
   the iron oxide powder includes ferrite containing at least one selected from Ni, Cu, Mn, and Zn.
[8] The magnetic paste according to any one of [1] to [7], wherein the magnetic powder (A) includes iron alloy-based metal powder containing at least one selected from Si, Cr, Al, Ni, and Co.
[9] The magnetic paste according to any one of [1] to [8], wherein a content of the magnetic powder (A) is 70% by mass or higher and 98% by mass or lower, with respect to 100% by mass of non-volatile components in the magnetic paste.
[10] The magnetic paste according to any one of [1] to [9], the magnetic paste is for through hole filling.
[11] A cured product of the magnetic paste according to any one of [1] to [10].
[12] A circuit board, comprising:
   a substrate having a through hole; and
   a cured product of the magnetic paste according to any one of [1] to [10], the magnetic paste being filled in the through hole.
[13] An inductor component, comprising the circuit board according to [12].

### Advantageous Effects of Invention

According to the present invention, there can be provided a magnetic paste having low viscosity and capable of achieving a cured product excellent in mechanical strength and adhesion strength, and provided the cured product, a circuit board, and an inductor component in each of which the magnetic paste is used.

### Brief Description of Drawings

FIG. 1 is a schematic cross-sectional view of a core substrate as an example of a method of manufacturing a circuit board of a first embodiment.
FIG. 2 is a schematic cross-sectional view of the core substrate having a through hole formed therein, as an example of the method of manufacturing the circuit board of the first embodiment.
FIG. 3 is a schematic cross-sectional view illustrating a state of the core substrate in which a plating layer is formed in the through hole, as an example of the method of manufacturing the circuit board of the first embodiment.
FIG. 4 is a schematic cross-sectional view illustrating a state of the core substrate in which the through hole is filled with a magnetic paste, as an example of the method of manufacturing the circuit board of the first embodiment.
FIG. 5 is a schematic cross-sectional view illustrating a state of the core substrate in which the filling magnetic paste is heat-cured, as an example of the method of manufacturing the circuit board of the first embodiment.
FIG. 6 is a schematic cross-sectional view illustrating a state of the core substrate observed after the polishing of a cured product, as an example of the method of manufacturing the circuit board of the first embodiment.
FIG. 7 is a schematic cross-sectional view illustrating a state of the core substrate in which a conductive layer is formed on a polished surface, as an example of the method of manufacturing the circuit board of the first embodiment.
FIG. 8 is a schematic cross-sectional view illustrating a state of the core substrate in which a pattern conductive layer is formed, as an example of the method of manufacturing the circuit board of the first embodiment.
FIG. 9 is a schematic cross-sectional view to describe a step (A) included in an example of a method of manufacturing a circuit board of a second embodiment.
FIG. 10 is a schematic cross-sectional view to describe the step (A) included in an example of the method of manufacturing the circuit board of the second embodiment.
FIG. 11 is a schematic cross-sectional view to describe a step (B) included in an example of the method of manufacturing the circuit board of the second embodiment.
FIG. 12 is a schematic cross-sectional view to describe a step (D) included in an example of the method of manufacturing the circuit board of the second embodiment.
FIG. 13 is a schematic plan view of an inductor component including the circuit board obtained by the method of manufacturing the circuit board of the second embodiment as an example, when seen from one side in the thickness direction of the inductor component.
FIG. 14 is a schematic diagram of an end cross-section of the inductor component including the circuit board obtained by the method of manufacturing the circuit board of the second embodiment as an example, when taken along a dot-and-dash line II-II.
FIG. 15 is a schematic plan view to describe a configuration of a first conductive layer of the inductor component including the circuit board obtained by the method of manufacturing the circuit board of the second embodiment as an example.

### Description of Embodiments

Hereinafter, embodiments of the present invention will be described with reference to the drawings. Note that the drawings just schematically illustrate the shape, size, and arrangement of constituents to the extent of aiding the understanding of the invention. The present invention is not limited by the following descriptions, and constituents may be suitably changed. In the drawings used for the following descriptions, similar constituents are assigned with the same reference sign, and any redundant description may be omitted. Configurations according to the embodiments of the present invention are not necessarily produced or used in accordance with the illustrated arrangement examples.

### Magnetic Paste

A magnetic paste of the present invention contains magnetic powder (A), an epoxy resin (B), an acidic dispersant (C), and a curing agent (D).

In the present invention, the magnetic paste contains the acidic dispersant (C), so that the magnetic paste has lower viscosity and is more excellent in printability. Furthermore, a cured product of the magnetic paste can have higher mechanical strength and higher adhesion strength. Furthermore, usually, the viscosity pot life of the magnetic paste is increased, and a cured product obtained therefrom usually can achieve enhancement of relative magnetic permeability in a frequency range of 10 to 200 MHz and achieve a reduction in magnetic loss in the frequency range.

The magnetic paste may further contain other additives (E), if needed. Hereinafter, components contained in the magnetic paste of the present invention will be described in detail.

### (A) Magnetic powder

The magnetic paste contains the magnetic powder (A) as a component (A). Examples of the magnetic powder (A) include pure iron powder; iron oxide powder, such as Mg-Zn-based ferrite, Fe-Mn-based ferrite, Mn-Zn-based ferrite, Mn-Mg-based ferrite, Cu-Zn-based ferrite, Mg-Mn-Sr-based ferrite, Ni-Zn-based ferrite, Ba-Zn-based ferrite, Ba-Mg-based ferrite, Ba-Ni-based ferrite, Ba-Co-based ferrite, Ba-Ni-Co-based ferrite, Y-based ferrite, ferric oxide powder (III), and triiron tetraoxide; iron alloy-based metal powder, such as Fe-Si-based alloy powder, Fe-Si-Al-based alloy powder, Fe-Cr-based alloy powder, Fe-Cr-Si-based alloy powder, Fe-Ni-Cr-based alloy powder, Fe-Cr-Al-based alloy powder, Fe-Ni-based alloy powder, Fe-Ni-Mo-based alloy powder, Fe-Ni-Mo-Cu-based alloy powder, Fe-Co-based alloy powder, and Fe-Ni-Co-based alloy powder; and amorphous alloys, such as a Co-group amorphous alloy.

In particular, the magnetic powder (A) is preferably at least one selected from iron oxide powder and iron alloy-based metal powder. The iron oxide powder preferably includes ferrite containing at least one selected from Ni, Cu, Mn, and Zn. The iron alloy-based metal powder preferably includes iron alloy-based metal powder containing at least one selected from Si, Cr, Al, Ni, and Co.

Commercially available magnetic powder may be used as the magnetic powder (A). Specific examples of the commercially available magnetic powder to be used include M05S, manufactured by Powdertech Co., Ltd.; PST-S, manufactured by Sanyo Special Steel Co., Ltd; AW2-08, AW2-08PF20F, AW2-08PF10F, AW2-08PF3F, Fe-3.5Si-4.5CrPF20F, Fe-50NiPF20F, and Fe-80Ni-4MoPF20F, manufactured by EPSON ATMIX Corporation; LD-M, LD-MH, KNI-106, KNI-106GSM, KNI-106GS, KNI-109, KNI-109GSM, and KNI-109GS, manufactured by JFE Chemical Corporation; KNS-415, BSF-547, BSF-029, BSN-125, BSN-125, BSN-714, BSN-828, S-1281, S-1641, S-1651, S-1470, S-1511, and S-2430, manufactured by TODA KOGYO CORP.; JR09P2, manufactured by Japan Metals & Chemicals Co., Ltd; Nanotek, manufactured by CIK NanoTek Corporation; JEMK-S and JEMK-H, manufactured by KINSEI MATEC CO., LTD; and yttrium iron oxide, manufactured by ALDRICH. The magnetic powder may be used alone, or two or more kinds thereof may be used in combination.

The magnetic powder (A) preferably has a spherical shape. A value (an aspect ratio) obtained by dividing the length of the major axis of the magnetic powder by the length of the minor axis of the magnetic powder is preferably 2 or less, more preferably 1.5 or less, and still more preferably 1.2 or less. Generally, when the magnetic powder has not a spherical shape but a flat shape, relative magnetic permeability can be more easily enhanced. However, the magnetic powder having a spherical shape is particularly preferably used because, usually, magnetic loss can be reduced and a paste having a desirable viscosity can be achieved.

From the viewpoint of enhancing relative magnetic permeability, the average particle diameter of the magnetic powder (A) is preferably 0.01 µm or larger, more preferably 0.5 µm or larger, and still more preferably 1 µm or larger. In addition, the average particle diameter of the magnetic powder (A) is preferably 10 µm or smaller, more preferably 9 µm or smaller, and still more preferably 8 µm or smaller.

The average particle diameter of the magnetic powder (A) can be measured by laser diffraction scattering based on the Mie scattering theory. Specifically, the average particle diameter can be measured in such a manner that the particle size distribution of the magnetic powder is created on the basis of volume by using a laser diffraction scattering type particle size distribution measurement device, and a median diameter in the particle size distribution is taken as the average particle diameter. As a measurement sample, what is obtained by dispersing the magnetic powder in water by supersonic waves can be preferably used. As the laser diffraction scattering type particle size distribution measurement device, for example, LA-500, manufactured by HORIBA, Ltd. or SALD-2200, manufactured by SHIMADZU CORPORATION can be used.

From the viewpoint of enhancing relative magnetic permeability, the specific surface area of the magnetic powder (A) is preferably 0.05 m²/g or larger, more preferably 0.1 m²/g or larger, and still more preferably 0.3 m²/g or larger. In addition, the specific surface area of the magnetic powder (A) is preferably 10 m²/g or smaller, more preferably 8 m²/g or smaller, and still more preferably 5 m²/g or smaller. The specific surface area of the magnetic powder (A) can be measured by the BET method.

From the viewpoints of enhancing relative magnetic permeability and reducing loss, the content (% by volume) of the magnetic powder (A) is preferably 40% by volume or higher, more preferably 50% by volume or higher, and still more preferably 60% by volume or higher, with respect to 100% by volume of non-volatile components in the magnetic paste. In addition, the content of the magnetic powder (A) is preferably 85% by volume or lower, more preferably 80% by volume or lower, and still more preferably 70% by volume or lower.

From the viewpoints of enhancing relative magnetic permeability and reducing a loss factor, the content (% by mass) of the magnetic powder (A) is preferably 70% by mass or higher, more preferably 75% by mass or higher, and still more preferably 80% by mass or higher, with respect to 100% by mass of non-volatile components in the magnetic paste. In addition, the content of the magnetic powder (A) is preferably 98% by mass or lower, more preferably 95% by mass or lower, and still more preferably 90% by mass or lower.

Note that, in the present invention, the content of each of the components in the magnetic paste represents the amount of the component when the amount of non-volatile components in the magnetic paste is taken as 100% by mass, unless otherwise specified.

### (B) Epoxy resin

The magnetic contains the epoxy resin (B) as a component (B). Examples of the epoxy resin (B) include a bisphenol A epoxy resin; a bisphenol F epoxy resin; a bisphenol S epoxy resin; a bisphenol AF epoxy resin; a dicyclopentadiene epoxy resin; a trisphenol epoxy resin; a phenol novolac epoxy resin; a tert-butyl-catechol epoxy resin; epoxy resins having a condensed ring structure, such as a naphthol novolac epoxy resin, a naphthalene epoxy resin, a naphthol epoxy resin, and an anthracene epoxy resin; a glycidyl amine epoxy resin; a glycidyl ester epoxy resin; a cresol novolac epoxy resin; a biphenyl epoxy resin; a linear aliphatic epoxy resin; an epoxy resin having a butadiene structure; an alicyclic epoxy resin; a heterocyclic epoxy resin; a spiro ring-containing epoxy resin; a cyclohexane dimethanol epoxy resin; a trimethylol epoxy resin; and a tetraphenyl ethane epoxy resin. The epoxy resins may be used alone or two or more kinds thereof may be used in combination. The epoxy resin (B) is preferably at least one selected from a bisphenol A epoxy resin and a bisphenol F epoxy resin.

The epoxy resin (B) preferably includes an epoxy resin having two or more epoxy groups in one molecule. The epoxy resin (B) preferably has an aromatic structure, and, in the case where the epoxy resin (B) includes two or more kinds of epoxy resins, at least one of the epoxy resins more preferably has an aromatic structure. The aromatic structure is a chemical structure generally defined as aromatic series, and includes polycyclic aromatic series and heteroaromatic rings. The ratio of an epoxy resin having two or more epoxy groups in one molecule is preferably 50% by mass or higher, more preferably 60% by mass or higher, and still more preferably 70% by mass or higher with respect to 100% by mass of non-volatile components of epoxy resins.

Epoxy resin includes an epoxy resin that remains liquid at a temperature of 25°C (hereinafter, sometimes referred to as "the liquid epoxy resin") and an epoxy resin that remains solid at a temperature of 25°C (hereinafter, sometimes referred to as "the solid epoxy resin"). The magnetic paste may contain only the liquid epoxy resin or may contain only the solid epoxy resin, as the epoxy resin (B), but, from the viewpoints of lowering the viscosity of the magnetic paste, the magnetic paste preferably contains the liquid epoxy resin.

The liquid epoxy resin is preferably a bisphenol A epoxy resin, a bisphenol F epoxy resin, a bisphenol AF epoxy resin, a naphthalene epoxy resin, a glycidyl ester epoxy resin, a glycidyl amine epoxy resin, a phenol novolac epoxy resin, a cycloaliphatic epoxy resin having an ester skeleton, a cyclohexanedimethanol epoxy resin, or an epoxy resin having a butadiene structure, and more preferably a glycidyl amine epoxy resin, a bisphenol A epoxy resin, a bisphenol F epoxy resin, a bisphenol AF epoxy resin, or a naphthalene epoxy resin. Specific examples of the liquid epoxy resin include HP4032, HP4032D, and HP4032SS (naphthalene epoxy resins), manufactured by DIC Corporation; 828US and jER828EL (bisphenol A epoxy resins), jER807 (a bisphenol F epoxy resin), and jER152 (a phenol novolac epoxy resin), manufactured by Mitsubishi Chemical Corporation; 630 and 630LSD, manufactured by Mitsubishi Chemical Corporation, and EP-3980S, manufactured by ADEKA Corporation, (glycidyl amine epoxy resins); ZX1059 (a mixed product of a bisphenol A epoxy resin and a bisphenol F epoxy resin), manufactured by Nippon Steel & Sumikin Chemical Co., Ltd.; EX-721 (a glycidyl ester epoxy resin), manufactured by Nagase ChemteX Corporation; Celloxide 2021P (a cycloaliphatic epoxy resin having an ester skeleton) and PB-3600 (an epoxy resin having a butadiene structure), manufactured by Daicel Corporation; and ZX1658 and ZX1658GS (cyclic aliphatic diglycidyl ethers (liquid 1,4-glycidyl cyclohexane)), manufactured by Nippon Steel Chemical Co., Ltd. These liquid epoxy resins may be used alone or two or more kinds thereof may be used in combination.

The solid epoxy resin is preferably a naphthalene tetrafunctional epoxy resin, a cresol novolac epoxy resin, a dicyclopentadiene epoxy resin, a trisphenol epoxy resin, a naphthol epoxy resin, a biphenyl epoxy resin, a naphthylene ether epoxy resin, an anthracene epoxy resin, a bisphenol A epoxy resin, or a tetraphenylethane epoxy resin, and more preferably a naphthalene tetrafunctional epoxy resin, a naphthol epoxy resin, or a biphenyl epoxy resin. Specific examples of the solid epoxy resin include HP4032H (a naphthalene epoxy resin), HP-4700 and HP-4710 (naphthalene tetrafunctional epoxy resins), N-690 (a cresol novolac epoxy resin), N-695 (a cresol novolac epoxy resin), HP-7200, HP-7200HH, and HP-7200H (dicyclopentadiene epoxy resins), EXA-7311, EXA-7311-G3, EXA-7311-G4, EXA-7311-G4S, and HP6000 (naphtylene ether epoxy resins), manufactured by DIC Corporation; EPPN-502H (a trisphenol epoxy resin), NC7000L (a naphthol novolac epoxy resin), NC3000H, NC3000, NC3000L, and NC3100 (biphenyl epoxy resins), manufactured by Nippon Kayaku Co., Ltd.; ESN475V (a naphthalene epoxy resin) and ESN485 (a naphthol novolac epoxy resin), manufactured by Nippon Steel & Sumikin Chemical Co., Ltd.; YX4000H and YL6121 (biphenyl epoxy resins), YX4000HK (a bixylenol epoxy resin), and YX8800 (an anthracene epoxy resin), manufactured by Mitsubishi Chemical Corporation; PG-100 and CG-500, manufactured by Osaka Gas Chemicals Co., Ltd., and YL7760, manufactured by Mitsubishi Chemical Corporation (bisphenol AF epoxy resins), and YL7800 (a fluorene epoxy resin), jER1010 (a solid bisphenol A epoxy resin), and jER1031S (a tetraphenylethane epoxy resin), manufactured by Mitsubishi Chemical Corporation. These solid epoxy resins may be used alone or two or more kinds thereof may be used in combination.

When a liquid epoxy resin and a solid epoxy resin are used in combination as the epoxy resin (B), the mass ratio of these epoxy resins (liquid epoxy resin: solid epoxy resin) preferably falls within a range of 1:0.1 to 1:4. When the mass ratio of the liquid epoxy resin to the solid epoxy resin falls within the above-mentioned range, for example, the effect of achieving a cured product having sufficient breaking strength can be produced. From the viewpoint of the above-mentioned effect, the mass ratio of the liquid epoxy resin to the solid epoxy resin (liquid epoxy resin: solid epoxy resin) falls within preferably a range of 1:0.3 to 1:3.5, more preferably a range of 1:0.6 to 1:3, and still more preferably a range of 1:0.8 to 1:2.5.

From the viewpoint of achieving a magnetic layer excellent in mechanical strength, the content of the epoxy resin (B) is preferably 1% by mass or higher, more preferably 3% by mass or higher, still more preferably 5% by mass or higher, and still more preferably 10% by mass or higher, with respect to 100% by mass of non-volatile components in the magnetic paste. The upper limit of the content of the epoxy resin is not limited to a particular content as long as the effect of the present invention is achieved, but, is preferably 30% by mass or lower, more preferably 25% by mass or lower, and still more preferably 20% by mass or lower.

The content (% by volume) of the epoxy resin (B) is preferably 1% by mass or higher, more preferably 3% by mass or higher, and still more preferably 5% by mass or higher, with respect to 100% by volume of non-volatile components in the magnetic paste. The upper limit of the content of the epoxy resin is not limited to a particular content as long as the effect of the present invention is achieved, but, is preferably 25% by mass or lower, more preferably 20% by mass or lower, and still more preferably 15% by mass or lower.

The epoxy equivalent of the epoxy resin (B) is preferably 50 g/eq. to 5000 g/eq., more preferably 50 g/eq. to 3000 g/eq., still more preferably 80 g/eq. to 2000 g/eq., and still more preferably 110 g/eq. to 1000 g/eq. When the epoxy equivalent is within the above-mentioned range, the crosslinking density of the cured product is sufficient, whereby a magnetic layer having lower surface roughness can be offered. Note that the epoxy equivalent can be measured in accordance with JIS K7236, and is the mass of a resin containing one equivalent of epoxy group.

The weight-average molecular weight of the epoxy resin (B) is preferably 100 to 5000, more preferably 250 to 3000, and still more preferably 400 to 1500. Here, the weight-average molecular weight of the epoxy resin is a weight-average molecular weight in terms of polystyrene, measured by gel permeation chromatography (GPC).

### (C) Acidic dispersant

The magnetic paste contains the acidic dispersant (C) as a component (C). As described above, a higher content of the magnetic powder (A) causes an increase in the viscosity of magnetic paste, and in addition, a decrease in the mechanical strength and adhesion strength of a cured product of the magnetic paste. In the present invention, the magnetic paste contains the acidic dispersant (C) as a dispersant, so that a lower viscosity can be achieved, compared with a paste not containing the acidic dispersant (C) (in other words, a paste having the same composition of that of the magnetic paste, except that the paste does not contain the component (C)). Thus, even when the content of the magnetic powder (A) is high, the viscosity of the magnetic paste can be inhibited from increasing, and furthermore the mechanical strength and adhesion strength of a cured product of the magnetic paste can be enhanced. Usually, the acidic dispersant (C) serving as a dispersant has no volatility, and accordingly can remain in a cured product obtained after curing.

In the present invention, the acidic dispersant (C) represents a dispersant being acidic, and "acidic" means that a pH according to the glass electrode method or the indicator method is less than 6. That is, a dispersant having a pH less than 6 according to a glass electrode method or an indicator method is defined as an acidic dispersant. In the case where both the glass electrode method and the indicator method are available for pH measurement, a pH value measured by the glass electrode method is given a higher priority. The pH of the acidic dispersant can be measured by the glass electrode method using a pH meter or the indicator method using a pH test paper. A specific pH measurement by the glass electrode method can be such that a measurement sample (22°C) prepared by dissolving the acidic dispersant in 30% by mass of an ethanol solution and having a dispersant concentration of 0.067 g/mL is measured using a pH meter having a glass electrode. A specific pH measurement by the indicator method can be such that a measurement sample (22°C) prepared by dissolving the acidic dispersant in acetone and having a dispersant concentration of 0.1 g/mL is dipped in a pH test paper and measured.

As the pH meter, a commercially available pH meter can be used. Examples of the commercially available pH meter include a pH meter, HM-41X, manufactured by DKK-TOA CORPORATION. As the pH test paper, a pH test paper capable of measuring a pH in an acidic region (for example, a pH test paper capable of measuring a pH of 0.0 to 14.0, a pH of 1.0 to 14.0, or a pH of 0.5 to 5.0) can be used, and examples of the pH test paper include a pH test paper, pH Test Paper pH 1 to 14 (pH measurement range: pH 1.0 to 14.0), manufactured by AS ONE CORPORATION.

As described above, in the case where both the glass electrode method and the indicator method are available for the pH measurement of the acidic dispersant, in the present invention, a value measured by the glass electrode method is defined as the pH of the acidic dispersant. In the case where the measurement by the glass electrode method cannot be performed because, for example, the acidic dispersant is insoluble in 30% by mass of an ethanol solution and accordingly 30% by mass of an ethanol solution having a dispersant concentration of 0.067 g/mL cannot be prepared, a pH measured by the indicator method is defined as the pH of the dispersant.

The pH of the acidic dispersant (C) is preferably less than 4, more preferably 3.8 or less, still more preferably 3.5 or less, and still more preferably 3.3 or less. The lower limit of the pH is 2 or more, more preferably 2.2 or more, and still more preferably 2.4 or more.

The acidic dispersant (C) include an acidic dispersant in a liquid state at a temperature of 25°C and an acidic dispersant in a solid state at a temperature of 25°C. From the viewpoint of further decreasing the viscosity of the magnetic paste, the magnetic paste preferably contains the liquid acidic dispersant as the acidic dispersant (C).

As the acidic dispersant (C), for example, an appropriate type of an acidic surfactant can be used. The acidic dispersant (C) may have an acidic functional group, such as a carboxy group, a sulfo group, or a phosphate group. The acidic dispersant (C) is preferably a polyether compound having, for example, a polyoxyalkylene chain or a polyether chain. The acidic dispersant (C) is preferably a compound having a polyether chain and an acidic functional group.

As the acidic dispersant (C), a commercially available acidic dispersant can be used. Specific examples of the commercially available acidic dispersant include C-20931 and SC-1015F (a polyfunctional comb-shaped functional polymer having an ionic group in a main chain and having a polyoxyalkylene chain in a graft chain), manufactured by NOF CORPORATION, DA-375 (a polyether phosphate compound-based dispersant), manufactured by Kusumoto Chemicals, Ltd.; Phosphanol series RS-410, RS-610, and RS-710 (pH 1.9) (phosphate-based dispersants), manufactured by TOHO Chemical Industry Co., Ltd.; and MALIALIM series AKM-0531, AFB-1521, SC-0505K, and SC-0708A, manufactured by NOF CORPORATION. The acidic dispersant (C) may be used alone or two or more kinds thereof may be used in combination.

From the viewpoint of remarkably exhibiting the effects of the present invention, the content of the acidic dispersant (C) is preferably 0.1% by mass or higher, more preferably 0.3% by mass or higher, and still more preferably 0.5% by mass or higher, with respect to 100% by mass of non-volatile components in the magnetic paste. The upper limit of the content is preferably 5% by mass or lower, more preferably 4% by mass or lower, and still more preferably 3% by mass or lower.

When the mass of the acidic dispersant (C) is taken as C1 with respect to 100% by mass of non-volatile components in the magnetic paste and the mass of the magnetic powder (A) is taken as A1 with respect to 100% by mass of the non-volatile components in the magnetic paste, (C1/A1) × 100 is preferably 0.1 or more, more preferably 0.5 or more, and still more preferably 1 or more, and preferably 10 or less, more preferably 5 or less, and still more preferably 3 or less. The masses of the components (A) and (C) are adjusted so as to achieve (C1/A1) × 100 within the above-mentioned range, whereby the desired effects of the present invention can be more remarkably achieved.

Preferable aspects of the acidic dispersant (C) can be as follows.
That is, in one embodiment, the acidic dispersant (C) may be RS-710, manufactured by TOHO Chemical Industry Co., Ltd.
In another embodiment, the acidic dispersant (C) may be an acidic dispersant (C) (except RS-710, manufactured by TOHO Chemical Industry Co., Ltd).
In still another embodiment, the acidic dispersant (C) may be RS-710, RS-610, or RS-710, manufactured by TOHO Chemical Industry Co., Ltd.
In still another embodiment, the acidic dispersant (C) may be an acidic dispersant (C) (except RS-710, RS-610, and RS-710, manufactured by TOHO Chemical Industry Co., Ltd).
In still another embodiment, the acidic dispersant (C) may be a phosphate-based dispersant.
In still another embodiment, the acidic dispersant (C) may be an acidic dispersant (C) (except a phosphate-based dispersant).

### (D) Curing agent

The magnetic paste contains the curing agent (D). The curing agent (D) includes an epoxy resin curing agent having the function of curing the epoxy resin (B) and a curing accelerator having the function of accelerating the curing rate of the epoxy resin (B). The magnetic paste preferably contains the epoxy resin curing agent as the curing agent (D). The magnetic paste may contain the curing accelerator as well as the epoxy resin curing agent, as the curing agent (D). The curing accelerator is usually used together with the epoxy resin curing agent.

### Epoxy Resin Curing Agent

Examples of the epoxy resin curing agent include a phenol-based epoxy resin curing agent, a naphthol-based epoxy resin curing agent, an active ester-based epoxy resin curing agent, an acid anhydride-based epoxy resin curing agent, a benzoxazine-based epoxy resin curing agent, a cyanate ester-based epoxy resin curing agent, and an imidazole-based epoxy resin curing agent. From the viewpoint of lowering the viscosity of the magnetic paste, the epoxy resin curing agent is preferably an acid anhydride-based epoxy resin curing agent or an imidazole-based epoxy resin curing agent. Furthermore, from the viewpoint of the mechanical strength of a cured product to be obtained, the epoxy resin curing agent is more preferably an imidazole-based epoxy resin curing agent. The epoxy resin curing agent may be used alone or two or more kinds thereof may be used in combination.

From the viewpoints of heat-resistance and water-resistance, the phenol-based epoxy resin curing agent and the naphthol-based epoxy resin curing agent are preferably a phenol-based epoxy resin curing agent having a novolac structure and a naphthol-based epoxy resin curing agent having a novolac structure, respectively. The phenol-based epoxy resin curing agent is preferably a nitrogen-containing phenol-based epoxy resin curing agent, more preferably a triazine skeleton-containing phenol-based epoxy resin curing agent, and still more preferably a triazine skeleton-containing phenol novolac epoxy resin curing agent.

Specific examples of the phenol-based epoxy resin curing agent and the naphthol-based epoxy resin curing agent include MEH-7700, MEH-7810, and MEH-7851, manufactured by Meiwa Plastic Industries, Ltd.; NHN, CBN, and GPH, manufactured by Nippon Kayaku Co., Ltd.; SN170, SN180, SN190, SN475, SN485, SN495V, SN375, and SN395, manufactured by Nippon Steel & Sumikin Chemical Co., Ltd.; TD-2090, LA-7052, LA-7054, LA-1356, LA-3018-50P, EXB-9500, HPC-9500, KA-1160, KA-1163, and KA-1165, manufactured by DIC Corporation; and GDP-6115L and GDP-6115H, manufactured by Gun Ei Chemical Industry Co., Ltd.

The active ester-based epoxy resin curing agent is, but not particularly limited to, generally preferably a compound having two or more highly reactive ester groups in one molecule, such as phenol esters, thiophenol esters, N-hydroxyamine esters, and esters of heterocyclic hydroxy compounds. The active ester-based epoxy resin curing agent is preferably obtained by a condensation reaction of a carboxylic acid compound and/or a thiocarboxylic acid compound with a hydroxy compound and/or a thiol compound. In particular, from the viewpoint of enhancing heat resistance, the active ester-based epoxy resin curing agent is preferably an active ester-based epoxy resin curing agent obtained from a carboxylic acid compound and a hydroxy compound, and more preferably an active ester-based epoxy resin curing agent obtained from a carboxylic acid compound and a phenol compound and/or a naphthol compound. Examples of the carboxylic acid compound include benzoic acid, acetic acid, succinic acid, maleic acid, itaconic acid, phthalic acid, isophthalic acid, terephthalic acid, and pyromellitic acid. Examples of the phenol compound and the naphthol compound include hydroquinone, resorcinol, bisphenol A, bisphenol F, bisphenol S, phenolphthalin, methylated bisphenol A, methylated bisphenol F, methylated bisphenol S, phenol, o-cresol, m-cresol, p-cresol, catechol, α-naphthol, β-naphthol, 1,5-dihydroxynaphthalene, 1,6-dihydroxynaphthalene, 2,6-dihydroxynaphthalene, dihydroxybenzophenone, trihydroxybenzophenone, tetrahydroxybenzophenone, phloroglucin, benzenetriol, a dicyclopentadiene diphenol compound, and phenol novolac. Here, the term "dicyclopentadiene diphenol compound" is a diphenol compound obtained by condensation of two molecules of phenol and one molecule of dicyclopentadiene.

Specifically, an active ester-based epoxy resin curing agent having a dicyclopentadiene diphenol structure, an active ester-based epoxy resin curing agent having a naphthalene structure, an active ester-based epoxy resin curing agent containing acetylated phenol novolac, and an active ester-based epoxy resin curing agent containing benzoylated phenol novolac are preferably used. The term "dicyclopentadiene diphenol structure" is a divalent structure composed of phenylene-dicyclopentylene-phenylene.

Examples of a commercially available active ester-based epoxy resin curing agent include EXB9451, EXB9460, EXB9460S, HPC-8000-65T, HPC-8000H-65TM, and EXB-8000L-65TM, manufactured by DIC Corporation, as the active ester-based epoxy resin curing agent having a dicyclopentadiene diphenol structure; EXB9416-70BK, manufactured by DIC Corporation, as the active ester compound having a naphthalene structure; DC808, manufactured by Mitsubishi Chemical Corporation, as the active ester-based epoxy resin curing agent containing acetylated phenol novolac; YLH1026, YLH1030, and YLH1048, manufactured by Mitsubishi Chemical Corporation, as the active ester-based epoxy resin curing agent containing benzoylated phenol novolac; and DC808, manufactured by Mitsubishi Chemical Corporation, as the active ester-based epoxy resin curing agent containing acetylated phenol novolac.

Examples of the acid anhydride-based epoxy resin curing agent include an epoxy resin curing agent having one or more acid anhydride groups in one molecule. Specific example of the acid anhydride-based epoxy resin curing agent include phthalic anhydride, tetrahydrophthalic anhydride, hexahydrophthalic anhydride, methyltetrahydrophthalic anhydride, methylhexahydrophthalic anhydride, methyl nadic anhydride, hydrogenated methyl nadic anhydride, trialkyltetrahydrophthalic anhydride, dodecenyl succinic anhydride, 5-(2,5-dioxotetrahydro-3-furanyl)-3-methyl-3-cyclohexene-1,2-dicarboxylic anhydride, trimellitic anhydride, pyromellitic anhydride, benzophenone tetracarboxylic dianhydride, biphenyl tetracarboxylic dianhydride, naphthalene tetracarboxylic dianhydride, oxydiphthalic dianhydride, 3,3'-4,4'-diphenylsulfone tetracarboxylic dianhydride, 1,3,3a,4,5,9b-hexahydro-5-(tetrahydro-2,5-dioxo-3-furanyl)-naphto[1,2-C]furan-1,3-dione, ethylene glycol bis(anhydrotrimellitate), and an acid anhydride polymer such as a styrene-maleic acid resin obtained by copolymerization of styrene and maleic acid.

Examples of a commercially available acid anhydride-based epoxy resin curing agent include HNA-100 and MH-700, manufactured by New Japan Chemical Co., Ltd.

Specific examples of the benzoxazine-based epoxy resin curing agent include HFB2006M, manufactured by Showa Highpolymer Co., Ltd., and P-d and F-a, manufactured by

### SHIKOKU CHEMICALS CORPORATION.

Examples of the cyanate ester-based epoxy resin curing agent include difunctional cyanate resins, such as bisphenol A dicyanate, polyphenol cyanate, oligo(3-methylene-1,5-phenylenecyanate), 4,4'-methylenebis(2,6-dimethylphenyl cyanate), 4,4'-ethylidenediphenyl dicyanate, hexafluorobisphenol A dicyanate, 2,2-bis(4-cyanate)phenylpropane, 1,1-bis(4-cyanatephenylmethane), bis(4-cyanate-3,5-dimethylphenyl)methane, 1,3-bis(4-cyanatephenyl-1-(methylethylidene))benzene, bis(4-cyanatephenyl)thioether, and bis(4-cyanatephenyl)ether; polyfunctional cyanate resins derived from, for example, phenol novolac and cresol novolac; and prepolymers in which these cyanate esters are partially triazinized. Specific examples of the cyanate ester-based epoxy resin curing agent include PT30 and PT60 (both are phenol novolac polyfunctional cyanate ester resins) and BA230 and BA230S75 (prepolymers in which bisphenol A dicyanate is partially or entirely triazinized to form a trimer), manufactured by Lonza Japan Ltd.

Examples of the imidazole-based epoxy resin curing agent include imidazole compounds, such as 2-methylimidazole, 2-undecylimidazole, 2-heptadecylimidazole, 1,2-dimethylimidazole, 2-ethyl-4-methylimidazole, 1,2-dimethylimidazole, 2-ethyl-4-methylimidazole, 2-phenylimidazole, 2-phenyl-4-methylimidazole, 1-benzyl-2-methylimidazole, 1-benzyl-2-phenylimidazole, 1-cyanoethyl-2-methylimidazole, 1-cyanoethyl-2-undecylimidazole, 1-cyanoethyl-2-ethyl-4-methylimidazole, 1-cyanoethyl-2-phenylimidazole, 1-cyanoethyl-2-undecylimidazolium trimellitate, 1-cyanoethyl-2-phenylimidazolium trimellitate, 2,4-diamino-6-[2'-methylimidazolyl-(1')]-ethyl-s-triazine, 2,4-diamino-6-[2'-undecylimidazolyl-(1')]-ethyl-s-triazine, 2,4-diamino-6-[2'-ethyl-4'-methylimidazolyl-(1')]-ethyl-s-triazine, a 2,4-diamino-6-[2'-methylimidazolyl-(1')]-ethyl-s-triazine isocyanuric acid adduct, a 2-phenylimidazole isocyanuric acid adduct, 2-phenyl-4,5-dihydroxymethylimidazole, 2-phenyl-4-methyl-5-hydroxymethylimidazole, 2,3-dihydro-1H-pyrrolo[1,2-a]benzimidazole, 1-dodecyl-2-methyl-3-benzylimidazolium chloride, 2-methylimidazoline, and 2-phenylimidazoline; and an adduct of an imidazole compound and an epoxy resin. The imidazole-based epoxy resin curing agent is preferably 2-ethyl-4-methylimidazole or 1-benzyl-2-phenylimidazole.

As the imidazole-based epoxy resin curing agent, a commercially available imidazole-based epoxy resin curing agent may be used, and examples thereof include 2MZA-PW and 2PHZ-PW, manufactured by SHIKOKU CHEMICALS CORPORATION, and P200-H50, manufactured by Mitsubishi Chemical Corporation.

The amount ratio of an epoxy resin to an epoxy resin curing agent is the ratio of [the total number of epoxy groups in the epoxy resin] : [the total number of reactive groups in the epoxy resin curing agent], and is preferably in a range of 1:0.2 to 1:2, more preferably in a range of 1:0.3 to 1:1.5, and still more preferably in a range of 1:0.4 to 1:1. Here, the reaction groups of the epoxy resin curing agent are, for example, an active hydroxyl group and an active ester group, and are different depending on the kind of the epoxy resin curing agent. The total number of epoxy groups in the epoxy resin is a value obtained by dividing the mass of non-volatile components in the epoxy resins by respective epoxy equivalents and summing the resulting values for all the epoxy resins. The total number of reactive groups in the epoxy resin curing agent is a value obtained by dividing the mass of non-volatile components in the epoxy resin curing agents by respective reactive group equivalents and summing the resulting values for all the epoxy resin curing agents. When the amount ratio of the epoxy resin to the epoxy resin curing agent is in the above-mentioned range, a resulting cured product has higher heat-resistance.

### Curing accelerator

Examples of the curing accelerator include an amine-based curing accelerator, an imidazole-based curing accelerator, a phosphorus-based curing accelerator, a guanidine-based curing accelerator, and a metal-based curing accelerator. From the viewpoint of lowering the viscosity of the magnetic paste, the curing accelerator is preferably an amine-based curing accelerator, an imidazole-based curing accelerator, or a guanidine-based curing accelerator. Furthermore, from the viewpoint of enhancing the mechanical strength of a cured product to be obtained, the curing accelerator is more preferably an imidazole-based curing accelerator. The curing accelerator may be used alone or two or more kinds thereof may be used in combination. The curing accelerator is usually used together with the epoxy resin curing agent.

Examples of the amine-based curing accelerator include trialkylamines such as triethylamine and tributylamine, 4-dimethylaminopyridine, benzyldimethylamine, 2,4,6-tris(dimethylaminomethyl)phenol, and 1,8-diazabicyclo(5,4,0)-undecene. The amine-based curing accelerator is preferably 4-dimethylaminopyridine or 1,8-diazabicyclo(5,4,0)-undecene.

As the amine-based curing accelerator, a commercially available amine-based curing accelerator may be used, and examples thereof include PN-50, PN-23, and MY-25, manufactured by Ajinomoto Fine-Techno Co., Inc.

The imidazole-based curing accelerator is the same as the above-mentioned imidazole-based epoxy resin curing agent. The above-mentioned imidazole-based epoxy resin curing agent sometimes functions as a curing accelerator when used together with another epoxy resin curing agent.

Examples of the phosphorus-based curing accelerator include triphenylphosphine, a phosphonium borate compound, tetraphenylphosphonium tetraphenylborate, n-butylphosphonium tetraphenylborate, tetrabutylphosphonium decanoate, (4-methylphenyl)triphenylphosphonium thiocyanate, tetraphenylphosphonium thiocyanate, and butyltriphenylphosphonium thiocyanate. The phosphorus-based curing accelerator is preferably triphenylphosphine or tetrabutylphosphonium decanoate.

Examples of the guanidine-based curing accelerator include dicyandiamide, 1-methylguanidine, 1-ethylguanidine, 1-cyclohexylguanidine, 1-phenylguanidine, 1-(o-tolyl)guanidine, dimethylguanidine, diphenylguanidine, trimethylguanidine, tetramethylguanidine, pentamethylguanidine, 1,5,7-triazabicyclo[4.4.0]dec-5-ene, 7-methyl-1,5,7-triazabicyclo[4.4.0]dec-5-ene, 1-methylbiguanide, 1-ethylbiguanide, 1-n-butylbiguanide, 1-n-octadecylbiguanide, 1,1-dimethylbiguanide, 1,1-diethylbiguanide, 1-cyclohexylbiguanide, 1-allylbiguanide, 1-phenylbiguanide, and 1-(o-tolyl)biguanide. The guanidine-based curing accelerator is preferably dicyandiamide or 1,5,7-triazabicyclo[4.4.0]dec-5-ene.

Examples of the metal-based curing accelerator include organic metal complexes and organic metal salts of metals such as cobalt, copper, zinc, iron, nickel, manganese, and tin. Specific examples of the organic metal complex include organic cobalt complexes, such as cobalt (II) acetylacetonate and cobalt (III) acetylacetonate, an organic copper complex such as copper (II) acetylacetonate, an organic zinc complex such as zinc (II) acetylacetonate, an organic iron complex such as iron (III) acetylacetonate, an organic nickel complex such as nickel (II) acetylacetonate, and an organic manganese complex such as manganese (II) acetylacetonate. Examples of the organic metal salt include zinc octoate, tin octoate, zinc naphthenate, cobalt naphthenate, tin stearate, and zinc stearate.

From the viewpoints of lowering the viscosity of the magnetic paste and enhancing the viscosity pot life thereof, the content of the curing agent (D) is preferably 0.1% by mass or higher, more preferably 0.3% by mass or higher, and still more preferably 0.5% by mass or higher, with respect to 100% by mass of non-volatile components in the magnetic paste. Furthermore, the upper limit of the content is preferably 5% by mass or lower, more preferably 3% by mass or lower, and still more preferably 1% by mass or lower.

When the mass of the curing agent (D) is taken as D1 with respect to 100% by mass of non-volatile components in the magnetic paste and the mass of the acidic dispersant (C) is taken as C1 with respect to 100% by mass of the non-volatile components in the magnetic paste, C1/D1 is preferably 0.1 or more, more preferably 0.5 or more, and still more preferably 1 or more, and preferably 10 or less, more preferably 5 or less, and still more preferably 3 or less. The masses of the components (C) and (D) are adjusted so as to achieve C1/D1 within the above-mentioned range, whereby the desired effects of the present invention can be more remarkably achieved.

When the mass of the magnetic powder (A) is taken as A1 with respect to 100% by mass of the non-volatile components in the magnetic paste, the mass of the epoxy resin (B) is taken as B1 with respect to 100% by mass of the non-volatile components in the magnetic paste, the mass of the acidic dispersant (C) is taken as C1 with respect to 100% by mass of the non-volatile components in the magnetic paste, and the mass of the curing agent (D) is taken as D1 with respect to 100% by mass of the non-volatile components in the magnetic paste, (B1+C1+D1)/A1 is preferably 0.01 or more, more preferably 0.05 or more, and still more preferably 0.1 or more, and preferably 1 or less, more preferably 0.5 or less, and still more preferably 0.3 or less. The masses of the components (A) to (D) are adjusted so as to achieve (B1+C1+D1)/A1 within the above-mentioned range, whereby the desired effects of the present invention can be more remarkably achieved.

When the mass of the magnetic powder (A) is taken as A1 with respect to 100% by mass of the non-volatile components in the magnetic paste, the mass of the acidic dispersant (C) is taken as C1 with respect to 100% by mass of the non-volatile components in the magnetic paste, and the mass of the curing agent (D) is taken as D1 with respect to 100% by mass of the non-volatile components in the magnetic paste, ((C1+D1)/A1) × 100 is preferably 0.1 or more, more preferably 0.5 or more, and still more preferably 1 or more, and preferably 10 or less, more preferably 5 or less, and still more preferably 3 or less. The masses of the components (A), (C), and (D) are adjusted so as to achieve ((C1+D1)/A1) × 100 within the above-mentioned range, whereby the desired effects of the present invention can be more remarkably achieved.

### (E) Other additives

The magnetic paste may further contain other additives (E), if needed. Examples of the other additives include a curing retardant, such as triethyl borate; an inorganic filler (except an inorganic filler equivalent to the magnetic powder); a thermoplastic resin; a fire retardant; an organic filler; organometallic compounds, such as an organocopper compound, an organozinc compound, and an organocobalt compound; and resin additives, such as a thickener, a defoaming agent, a leveling agent, an adhesion imparting agent, and a colorant.

The content of the above-mentioned organic solvent in the magnetic paste is preferably less than 1.0% by mass, more preferably 0.8% by mass or lower, still more preferably 0.5% by mass or lower, and particularly preferably 0.1% by mass or lower, with respect to the total mass of the magnetic paste. The lower limit of the content of the organic solvent is not particularly limited, but is 0.001% by mass or higher, or alternatively the magnetic paste does not contain the organic solvent. Even the magnetic paste does not contain any organic solvent, the viscosity of the magnetic paste can be made lower. When the magnetic paste contains the organic solvent in smaller amounts, occurrence of a void due to volatilization of the organic solvent can be prevented.

The magnetic paste may or may not contain, for example, an anionic dispersant, such as sodium dodecylbenzene sulfonate, sodium lauryl sulfate, or an ammonium salt of polyoxyethylene alkylether sulfate; or a nonionic dispersant, such as an organosiloxane-based dispersant, acetyleneglycol, polyoxyethylene alkyl ether, polyoxyethylene alkyl ester, polyoxyethylene sorbitan fatty acid ester, polyoxyethylene alkyl phenyl ether, polyoxyethylene alkylamine, or polyoxyethylene alkyl amide.
Examples of a commercially available organosiloxane-based dispersant include BYK347 and BYK348, manufactured by BYK-Chemie GmbH.
Examples of a commercially available polyoxyalkylene-based dispersant include HKM-50A and HKM-150A, manufactured by NOF CORPORATION. The polyoxyalkylene-based dispersant is a general term for polyoxyethylene alkyl ether, polyoxyethylene alkyl ester, polyoxyethylene sorbitan fatty acid ester, polyoxyethylene alkyl phenyl ether, polyoxyethylene alkylamine, and polyoxyethylene alkyl amide.
Examples of commercially available acetyleneglycol include SURFYNOL 82, 104, 440, 465, and 485, and Olefin Y, manufactured by Air Products and Chemicals Inc.

In one embodiment, the magnetic paste may contain magnetic powder, an organic layered silicate mineral, and a binder resin. In another embodiment, the magnetic paste may not be a magnetic paste containing magnetic powder, an organic layered silicate mineral, and a binder resin. For detailed description on the magnetic powder, the organic layered silicate mineral, and the binder resin that may be contained in the magnetic paste according to these embodiments, Japanese Patent Application No. 2018-139537 can be referred to.

In one embodiment, the magnetic paste may contain magnetic powder having an average particle diameter of 1 µm or larger, an epoxy resin, a reactive diluent, a curing agent, and a filler having an average particle diameter of less than 1 µm. In another embodiment, the magnetic paste may not be a magnetic paste containing magnetic powder having an average particle diameter of 1 µm or larger, an epoxy resin, a reactive diluent, a curing agent, and a filler having an average particle diameter of less than 1 µm. For detailed description on the magnetic powder having an average particle diameter of 1 µm or larger, the epoxy resin, the reactive diluent, the curing agent, and the filler having an average particle diameter of less than 1 µm each of which may be contained in the magnetic paste according to these embodiments, Japanese Patent Application No. 2018-219667 can be referred to.

### Method for producing magnetic paste

The magnetic paste can be produced, for example, by stirring blending components with a stirrer, such as a three-roll mill or a rotary mixer.

### Physical properties and other properties of magnetic paste

The magnetic paste has the property of having a low viscosity. Hence, the magnetic paste is excellent in printability. The viscosity at 25°C of the magnetic paste is preferably 200 Pa·s or lower, more preferably 150 Pa·s or lower, and still more preferably lower than 100 Pa·s, and preferably 10 Pa·s or higher, more preferably 20 Pa·s or higher, and still more preferably 30 Pa·s or higher. The viscosity can be measured using, for example, an E-type viscometer (RE-80U, manufactured by TOKI SANGYO CO., LTD.), and the measurement can be performed by a method described in detail in the later-mentioned examples.

The magnetic paste usually has the property of improving the viscosity pot life. Specifically, the viscosity at 25°C of the magnetic paste allowed to stand for 1 week is preferably 200 Pa·s or lower, more preferably 180 Pa·s or lower, still more preferably 150 Pa·s or lower, and still more preferably lower than 100 Pa·s, and preferably 30 Pa·s or higher, more preferably 40 Pa·s or higher, and still more preferably 50 Pa·s or higher. The viscosity of the magnetic paste allowed to stand for 1 week can be measured using, for example, an E-type viscometer (RE-80U, manufactured by TOKI SANGYO CO., LTD.), and the measurement can be performed by a method described in detail in the later-mentioned examples.

A cured product obtained by heating the magnetic paste at 180°C for 90 minutes has the property of being excellent in mechanical strength (tensile break strength). Accordingly, the cured product brings about a magnetic layer excellent in tensile break strength. The tensile break strength is preferably 40 MPa or higher, more preferably 45 MPa or higher, and still more preferably 50 MPa or higher. The upper limit of the tensile break strength is not particularly limited, but may be 100 MPa or lower, for example. The tensile break strength can be measured by a method described in the later-mentioned examples.

The cured product obtained by heating the magnetic paste at 180°C for 90 minutes has the property of being excellent in plating adhesion to a plating layer. Accordingly, the cured product brings about the magnetic layer excellent in adhesion strength to the plating layer. The adhesion strength, which indicates plating adhesion, is preferably 0.2 kgf/cm or more, more preferably 0.21 kgf/cm or more, and still more preferably 0.22 kgf/cm or more.
The upper limit of the adhesion strength is not particularly limited, but may be 10 kgf/cm or less, for example. The adhesion strength can be measured by a method described in the later-mentioned examples.

The cured product obtained by heating the magnetic paste at 180°C for 90 minutes usually has the property of having a high relative magnetic permeability at a frequency of 100 MHz. Accordingly, the cured product brings about the magnetic layer having a high relative magnetic permeability. The relative magnetic permeability of this cured product at a frequency of 100 MHz is preferably 1 or more, more preferably 2 or more, and still more preferably 4 or more. The upper limit of the relative magnetic permeability is not particularly limited, but may be 20 or less, for example.

The cured product obtained by heating the magnetic paste at 180°C for 90 minutes usually has the property of having a smaller magnetic loss at a frequency of 100 MHz. Accordingly, the cured product brings about a magnetic layer having a smaller magnetic loss. The magnetic loss of this cured product at a frequency of 100 MHz is preferably 1 or less, more preferably 0.9 or less, and still more preferably 0.8 or less. The lower limit of the magnetic loss is not particularly limited, but may be 0.001 or more, for example.

### Cured product

A cured product of the present invention can be obtained by curing the magnetic paste of the present invention. As conditions for curing the magnetic paste, conditions at the later mentioned step (2) may be used. Furthermore, before heat-cured, the magnetic paste may be preheated, and may be subjected to heating two or more times including the preheating.

### Magnetic sheet

A magnetic sheet includes: a support; and a resin composition layer provided on the support and formed of the magnetic paste.

From the viewpoint of thinner, the thickness of the resin composition layer is preferably 250 µm or less, more preferably 200 µm or less, still more preferably 150 µm or less, still more preferably 100 µm or less. The lower limit of the thickness of the resin composition layer is not particularly limited, but may be usually 5 µm or more, for example.

Examples of the support include a film made of a plastic material, a metal foil, and release paper. A film made of a plastic material and a metal foil are preferably used.

In the case where a film made of a plastic material is used as the support, examples of the plastic material include polyesters, such as polyethylene terephthalate (hereinafter, sometimes referred to as "PET") and polyethylenenaphthalate (hereinafter, sometimes referred to as "PEN"), polycarbonate (hereinafter, sometimes referred to as "PC"), acrylic such as polymethylmethacrylate (PMMA), cyclic polyolefin, triacetyl cellulose (TAC), polyether sulfide (PES), polyether ketone, and polyimide. Among them, polyethylene terephthalate and polyethylene naphthalate are preferably used, and polyethylene terephthalate, which is inexpensive, is particularly preferably used.

In the case where a metal foil is used as the support, examples of the metal foil include copper foil and aluminum foil, and copper foil is preferably used. As the copper foil, a foil made of a single metal of copper may be used, or alternatively a foil made of an alloy of copper and another metal (for example, tin, chromium, silver, magnesium, nickel, zirconium, silicon, or titanium) may be used.

A surface of the support to be joined to the resin composition layer may be subjected to mat treatment or corona treatment.

As the support, use may be made of a support provided with a release layer, the support having the release layer on a surface to be joined to the resin composition layer. Examples of a release agent used for the release layer of the support provided with the release layer include one or more release agents selected from the group consisting of alkyd resin, polyolefin resin, urethane resin, and silicone resin. As the support provided with the release layer, a commercially available one may be used, and examples thereof include PET films having a release layer containing an alkyd resin-based release agent as a principal component, such as SK-1, AL-5, and AL-7, manufactured by LINTEC Corporation; Lumirror T60, manufactured by Toray Industries, Inc.; Purex, manufactured by TEIJIN LIMITED; and Unipeel, manufactured by UNITIKA LTD.

The thickness of the support is not particularly limited, but may be preferably in a range of 5 µm to 75 µm, and more preferably in a range of 10 µm to 60 µm. Note that, in the case where the support provided with the release layer is used, the thickness of the entirety of the support provided with the release layer is preferably in the above-mentioned range.

The magnetic sheet can be manufactured by, for example, preparing resin varnish by dissolving the magnetic paste in an organic solvent, and applying this resin varnish onto the support by a die coater or the like, and furthermore drying the resin varnish to form a resin composition layer. Alternatively, the magnetic sheet can be manufactured by applying the magnetic paste directly onto the support by a die coater to form a resin composition layer.

Examples of the organic solvent may include ketones, such as acetone, methyl ethyl ketone (MEK), and cyclohexanone; acetate esters, such as ethyl acetate, butyl acetate, cellosolve acetate, propylenegylcol monomethyl ether acetate, and carbitol acetate; carbitols, such as cellosolve and butyl carbitol; aromatic hydrocarbons, such as toluene and xylene; and amide-based solvents, such as dimethylformamide, dimethylacetamide (DMAc), and N-methylpyrrolidone. The organic solvent may be used alone or two or more kinds thereof may be used in combination.

The drying may be performed by a well-known method, such as heating or hot-air spraying. Conditions for the drying are not particularly limited, but, the drying is performed so that the content of the organic solvent in the resin composition layer is 10% by mass or lower, and preferably 5% by mass or lower. Although depending on the boiling point of the organic solvent in the resin varnish, for example, when use is made of resin varnish containing 30% by mass to 60% by mass of the organic solvent, the resin composition layer can be formed by drying the resin varnish at 50°C to 150°C for 3 minutes to 10 minutes.

In the magnetic sheet, on a surface of the resin composition layer, the surface being not joined to the support, (that is, a surface on a side opposite to the support), a protective film corresponding to the support can be further laminated. The thickness of the protective film is not particularly limited, but is 1 µm to 40 µm, for example. The lamination of the protective film can prevent the attachment of dusts and the like or the generation of scratch on the surface of the resin composition layer. The magnetic sheet can be wound in a roll form and stored. When the magnetic sheet has the protective film, the magnetic sheet becomes available only after the protective film is peeled off.

Circuit board and manufacturing method of same A circuit board of a first embodiment includes: a substrate having a through hole; and a cured product of the magnetic paste of the present invention that is filled in the through hole. A circuit board of a second embodiment includes a magnetic layer formed of a cured product of a resin composition layer of a magnetic sheet. Hereinafter, the first embodiment and the second embodiment of the respective methods of manufacturing the circuit boards will be described. Note that the method of manufacturing a circuit board according to the present invention is not limited to the first and second embodiments exemplified below.

### First embodiment

The circuit board of the first embodiment is manufactured, for example, by a manufacturing method including the following steps (1) to (4). In the first embodiment, a magnetic layer is preferably formed using the magnetic paste. The manufacturing method includes the steps of:
(1) filling a through hole of the substrate having the through hole with the magnetic paste;
(2) thermally curing the magnetic paste to obtain a cured product;
(3) polishing a surface of the cured product or the magnetic paste; and
(4) forming a conductive layer in the polished surface of the cured product.

The method of manufacturing the circuit board of the present invention may be performed in the order of the steps (1) to (4), or in such a manner that the step (2) may be performed after the step (3).

Hereinafter, the above-described steps (1) to (4) for manufacturing the circuit board will be described in detail.

### Step (1)

The step (1) may include the step of preparing the magnetic paste. The magnetic paste is as described above.

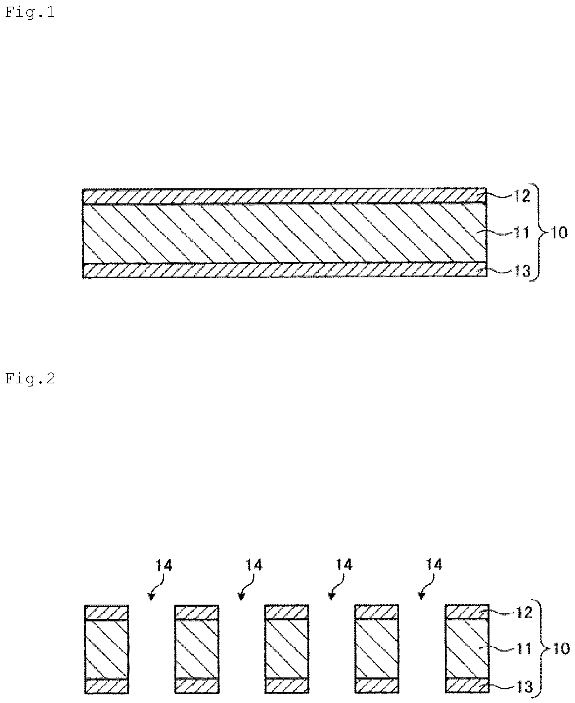

The step (1) may include the step of preparing a core substrate 10 including a support substrate 11, a first metal layer 12, and a second metal layer 13, the first metal layer 12 and the second metal layer 13 being provided in both surfaces of the support substrate 11 respectively and formed of, for example, copper foil, as illustrated in an example of FIG. 1. Examples of a material of the support substrate 11 include a glass epoxy substrate, a metal substrate, a polyester substrate, a polyimide substrate, a bismaleimide triazine (BT) resin substrate, and a thermosetting polyphenylene ether substrate. Examples of a material of the first and the second metal layers include a copper foil with carrier and a material of a later-mentioned conductive layer.

As illustrated in an example in FIG. 2, the step (1) may include the step of forming a through hole 14 in the core substrate 10. The through hole 14 can be formed by, for example, drilling, laser irradiation, or plasma irradiation. Specifically, the through hole 14 can be formed in such a manner that a through hole is formed in the core substrate 10 by drilling, for example.

The formation of the through hole 14 can be performed using a commercially available drilling apparatus. Examples of the commercially available drilling apparatus include ND-1S211, manufactured by Hitachi Via Mechanics, Ltd.

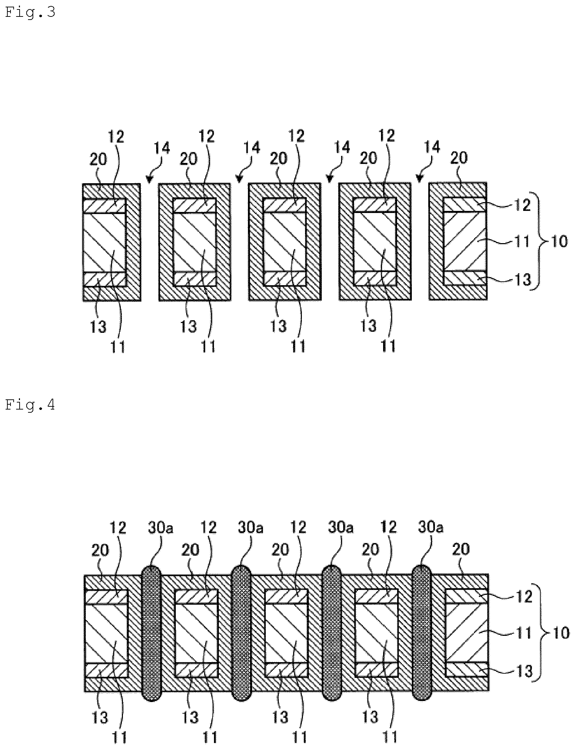

After the formation of the through hole 14 in the core substrate 10, the step (1) may include the step of roughening the core substrate 10 and forming a plating layer 20 inside the through hole 14, on a surface of the first metal layer 12, and on a surface of the second metal layer 13, as illustrated in an example in FIG. 3.

As the above-described roughening, any of dry roughening and wet roughening may be performed. Examples of the dry roughening include plasma processing. Examples of the wet roughening include a method in which swelling treatment with a swelling solution, roughening treatment with an oxidant, and neutralization treatment with a neutralization solution are performed in this order.

The plating layer 20 is formed by plating. A procedure for forming the plating layer 20 by the plating is the same as that for forming a conductive layer at the step (4) described later.

After preparing the core substrate 10 having the plating layer 20 formed inside the through hole 14, the through hole 14 is filled with a magnetic paste 30a, as illustrated in an example in FIG. 4. Examples of a filling method include a method of filling the through hole 14 with the magnetic paste 30a via a squeegee, a method of filling with the magnetic paste 30a via a cartridge, a method of filling with the magnetic paste 30a by mask printing, a roll coating method, and an inkjet method.

### Step (2)

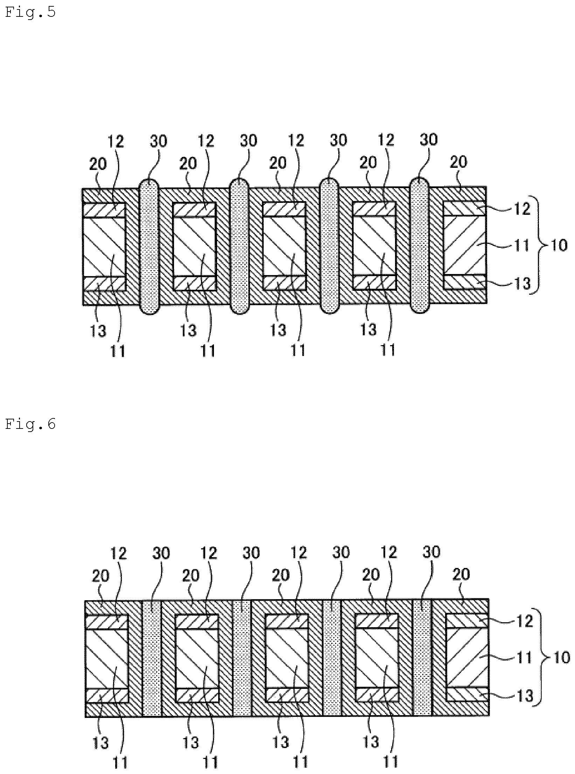

At the step (2), after the through hole 14 is filled with the magnetic paste 30a, the magnetic paste 30a is thermally cured to form a cured product layer (magnetic layer) 30 in the through hole 14, as illustrated in an example in FIG. 5. Conditions for thermally curing the magnetic paste 30a are different in accordance with a composition and a kind of the magnetic paste 30a, but the curing temperature is preferably 120°C or higher, more preferably 130°C or higher, and still more preferably 150°C or higher, and preferably 240°C or lower, more preferably 220°C or lower, and still more preferably 200°C or lower. Time to cure the magnetic paste 30a is preferably 5 minutes or longer, more preferably 10 minutes or longer, and still more preferably 15 minutes or longer, and preferably 120 minutes or shorter, more preferably 100 minutes or shorter, and still more preferably 90 minutes or shorter.

The degree of cure of the magnetic layer 30 at the step (2) is preferably 80% or higher, more preferably 85% or higher, and still more preferably 90% or higher. The degree of cure can be measured, for example, using a differential scanning calorimeter.

Prior to the thermally curing of the magnetic paste 30a, the magnetic paste 30a may be subjected to preheating treatment to be heated at a temperature lower than the curing temperature. For example, prior to the thermally curing of the magnetic paste 30a, the magnetic paste 30a may be preheated, normally at a temperature of 50°C or higher and less than 120°C (preferably 60°C or higher and 110°C or lower, and more preferably 70°C or higher and 100°C or lower), normally for 5 minutes or longer (preferably for 5 minutes to 150 minutes, and more preferably for 15 minutes to 120 minutes).

### Step (3)

At the step (3), as illustrated in an example in FIG. 6, an excessive magnetic layer 30 protruding from or adhering to the core substrate 10 is removed by polishing to planarize the surface. As a method for the polishing, use can be made of a method capable of polishing the excessive magnetic layer 30 protruding from or adhering to the core substrate 10. Examples of the method for the polishing include buffing and belt polishing. Examples of a commercially available buffing apparatus include NT-700IM, manufactured by ISHIIHYOKI CO., LTD.

From the viewpoint of enhancing plating adhesion, the arithmetic mean roughness (Ra) of the polished surface of the magnetic layer is preferably 300 nm or more, more preferably 350 nm or more, and still more preferably 400 nm or more. The upper limit is preferably 1000 nm or less, more preferably 900 nm or less, and still more preferably 800 nm or less. The surface roughness (Ra) can be measured, for example, using a non-contact type surface roughness meter.

In the case where the step (3) is performed after the step (2), for the purpose of, for example, further enhancing the degree of cure of the magnetic layer, heat treatment may be performed, if needed, after the step (2) and before the step (3). It is sufficient that the temperature for the heat treatment is in accordance with the above-described curing temperature, and is preferably 120°C or higher, more preferably 130°C or higher, and still more preferably 150°C or higher, and preferably 240°C or lower, more preferably 220°C or lower, and still more preferably 200°C or lower. Time for the heat treatment is preferably 5 minutes or longer, more preferably 10 minutes or longer, and still more preferably 15 minutes or longer, and preferably 90 minutes or shorter, more preferably 70 minutes or shorter, and still more preferably 60 minutes or shorter.

In the case where the step (3) is performed before the step (2), preheating treatment in which heating is performed at a temperature lower than the curing temperature of the magnetic paste may be performed before the step (3). The temperature for the preheating treatment is preferably 100°C or higher, more preferably 110°C or higher, and still more preferably 120°C or higher, and preferably 240°C or lower, more preferably 220°C or lower, and still more preferably 200°C or lower. Time for the heat treatment is preferably 5 minutes or longer, more preferably 10 minutes or longer, and still more preferably 15 minutes or longer, and preferably 90 minutes or shorter, more preferably 70 minutes or shorter, and still more preferably 60 minutes or shorter.

### Step (4)

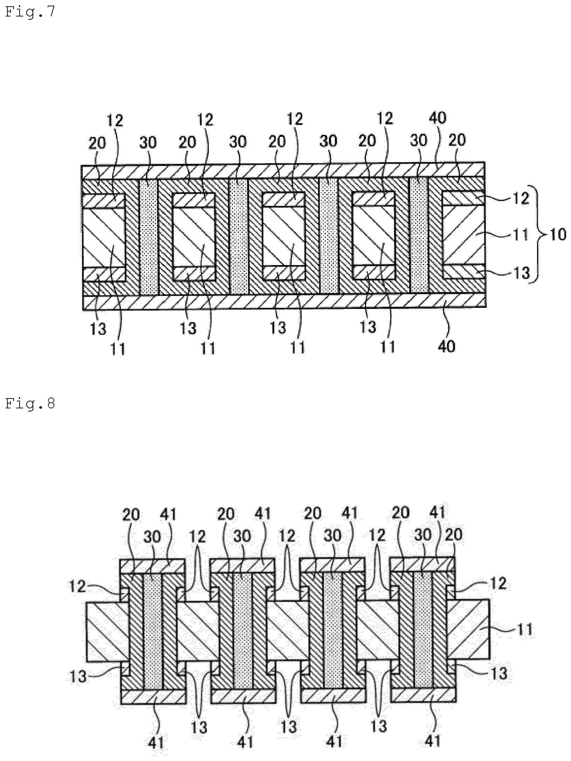

At the step (4), a conductive layer 40 is formed on the polished surface of the magnetic layer 30 and the plating layer 20, as illustrated in an example in FIG. 7. Furthermore, after the formation of the conductive layer 40, the conductive layer 40, the first metal layer 12, the second metal layer 13, and the plating layer 20 may be partially removed by a treatment such as etching to form a pattern conductive layer 41, as illustrated in an example in FIG. 8. The present invention does not include the step of roughening the magnetic layer because the cured product was polished at the step (3). In FIG. 7, the conductive layer 40 is formed on both surfaces of the core substrate 10, but, the conductive layer 40 may be formed on only one surface of the core substrate 10.

Examples of a method for forming the conductive layer include plating, sputtering, and vapor deposition. Among these methods, plating is preferably used. In a preferable embodiment, a surface of the cured product is subjected to plating with an appropriate method, such as a semi-additive method or a full-additive method, to form a pattern conductive layer having a desired wiring pattern. Examples of a material of the conductive layer include single metals, such as gold, platinum, palladium, silver, copper, aluminum, cobalt, chromium, zinc, nickel, titanium, tungsten, iron, tin, and indium; and alloys of two or more kinds of metals selected from the group consisting of gold, platinum, palladium, silver, copper, aluminum, cobalt, chromium, zinc, nickel, titanium, tungsten, iron, tin, and indium. Among these metals, from the viewpoints of for example, versatility, cost, and ease of patterning, chromium, nickel, titanium, aluminum, zinc, gold, palladium, silver, copper, a nickel-chrome alloy, a copper-nickel alloy, or a copper-titanium alloy is preferably used. Chromium, nickel, titanium, aluminum, zinc, gold, palladium, silver, copper, or a nickel-chrome alloy is more preferably used. Copper is still more preferably used.

Here, an embodiment example in which the pattern conductive layer is formed on the polished surface of the cured product will be described in detail. A plating seed layer is formed on the polished surface of the cured product by non-electrolytic plating. Subsequently, an electrolytic plating layer is formed on the formed plating seed layer by electrolytic plating, and an unnecessary plating seed layer is removed by, for example, etching, if needed, so that a conductive layer having a desired circuit pattern can be formed. After the formation of the conductive layer, annealing treatment may be performed, if needed, for the purpose of, for example, enhancing the peel strength of the conductive layer. The annealing treatment can be performed by, for example, heating a circuit board at 150°C to 200°C for 20 to 90 minutes.

From the viewpoint of thinner, the thickness of the pattern conductive layer is preferably 70 µm or less, more preferably 60 µm or less, still more preferably 50 µm or less, still more preferably 40 µm or less, and particularly preferably 30 µm or less, 20 µm or less, 15 µm or less, or 10 µm or less. The lower limit of the thickness is preferably 1 µm or more, more preferably 3 µm or more, and still more preferably 5 µm or more.

### Second embodiment

The circuit board of the second embodiment includes a magnetic layer formed of a cured product of the magnetic paste. In the second embodiment the magnetic layer is preferably formed using a magnetic sheet. Hereinafter, the second embodiment of the method of manufacturing a substrate product will be described. The same description as that for the first embodiment will be appropriately omitted.

The circuit board of the second embodiment is manufactured, for example, by a manufacturing method including the following steps (A) to (D).

The manufacturing method includes the steps of:
(A) laminating a magnetic sheet on an inner layer substrate so that a resin composition layer is contact with the inner layer substrate to form a magnetic layer;
(B) perforating the magnetic layer;
(C) polishing a surface of the magnetic layer; and
(D) forming a conductive layer in the polished surface of the magnetic layer.

Hereinafter, the steps (A) to (D) for manufacturing the circuit board will be described in detail.

### Step (A)

The step (A) is the step of laminating a magnetic sheet on an inner layer substrate so that a resin composition layer is contact with the inner layer substrate to form a magnetic layer. One embodiment of the step (A) is such that a magnetic sheet is laminated on an inner layer substrate so that a resin composition layer is contact with the inner layer substrate, and the resin composition layer is thermally cured to form a magnetic layer.

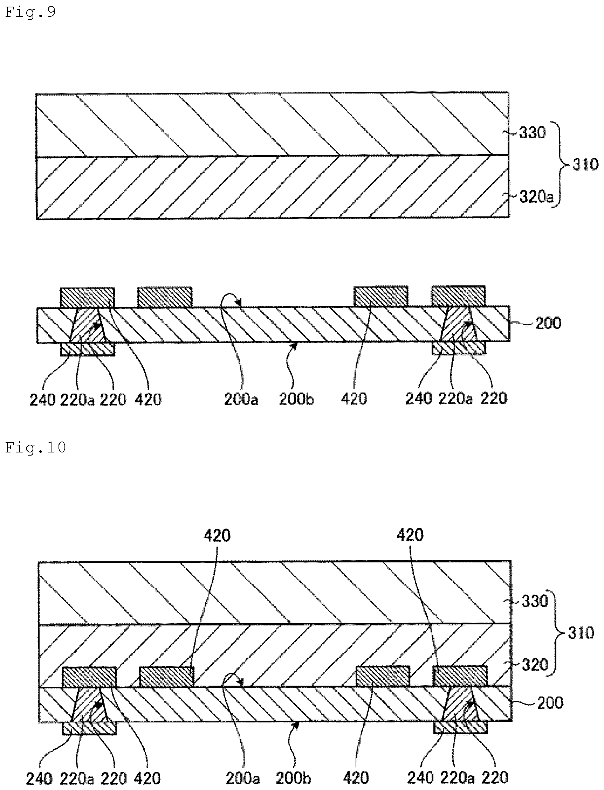

At the step (A), as illustrated in one example in FIG. 9, a magnetic sheet 310 including a support 330 and a resin composition layer 320a provided on the support 330 is laminated on an inner layer substrate 200 so that the resin composition layer 320a is contact with the inner layer substrate 200.

The inner layer substrate 200 is an insulating substrate. Examples of a material of the inner layer substrate 200 include insulating base materials, such as a glass epoxy substrate, a metal substrate, a polyester substrate, a polyimide substrate, a bismaleimide triazine (BT) resin substrate, and a thermosetting polyphenylene ether substrate. The inner layer substrate 200 may be an inner layer circuit board in which, for example, wiring are laid within a thickness range thereof.

As illustrated in one example in FIG. 9, the inner layer substrate 200 includes: a first conductive layer 420 provided on a first main surface 200a; and an external terminal 240 provided on a second main surface 200b. The first conductive layer 420 may include a plurality of wirings. In the example in the figure, only wiring that constitutes a coil-shaped conductive structure 400 of an inductor element is illustrated. The external terminal 240 is a terminal to be electrically connected to a not-illustrated external device or the like. The external terminal 240 can constitute a part of conductive layer provided on the second main surface 200b.

A conductive material which can constitute the first conductive layer 420 and the external terminal 240 is the same as the material of the conductive layer described at the step (4) of the first embodiment.

The first conductive layer 420 and the external terminal 240 may have a single layer structure, or alternatively have a multilayered structure in which two or more of single metal layers or alloy layers that are formed of different metals or alloys thereof are laminated. The thicknesses of the first conductive layer 420 and the external terminal 240 are the same as that of the second conductive layer 440 described later.

The ratio of line (L) / space (S) of the first conductive layer 420 and the external terminal 240 is not particularly limited, but, from the viewpoints of achieving a magnetic layer having reduced projections-and-recesses in a surface thereof and thereby being excellent in surface smoothness, the ratio of line (L) / space (S) is usually 900/900 µm or less, preferably 700/700 µm or less, more preferably 500/500 µm or less, still more preferably 300/300 µm or less, and still more preferably 200/200 µm or less. The lower limit of the line/space ratio is not particularly limited, but, from the viewpoint of making better the embedding of the resin composition layer into a space, the lower limit is preferably 1/1 µm or more.

The inner layer substrate 200 may have a plurality of through holes 220 penetrating the inner layer substrate 200 from the second main surface 200b to the first main surface 200a. Through hole wiring 220a is provided in each of the through holes 220. The through hole wiring 220a is configured to electrically connect the first conductive layer 420 to the external terminal 240.

The resin composition layer 320a and the inner layer substrate 200 can be laminated by, for example, thermal pressing the magnetic sheet 310 to the inner layer substrate 200 from a support 330 side. Examples of a member (hereinafter, also referred to as a thermal pressing member) for thermal pressing the magnetic sheet 310 to the inner layer substrate 200 include a heated metal plate (for example, a stainless steel (SUS) panel) and a metal roll (a SUS roll). Note that, it is not preferable that the thermal pressing member is brought into direct contact with the magnetic sheet 310 and pressed thereon, but, the thermal pressing member is preferably pressed on the magnetic sheet 310 via a sheet made of an elastic material such as heat-resistant rubber so that the magnetic sheet 310 satisfactorily extends along projections and recesses of a surface of the inner layer substrate 200.

The temperature for the thermal pressing is in a range of preferably 80°C to 160°C, more preferably 90°C to 140°C, and still more preferably 100°C to 120°C. The pressure for the thermal pressing is in a range of preferably 0.098 MPa to 1.77 MPa and more preferably 0.29 MPa to 1.47 MPa. The time period for the thermal pressing is in a range of preferably 20 seconds to 400 seconds and more preferably 30 seconds to 300 seconds. The laminating of the magnetic sheet to the inner layer substrate is preferably performed at a reduced pressure of 26.7 hPa or lower.

The laminating of the resin composition layer 320a of the magnetic sheet 310 and the inner layer substrate 200 can be performed using a commercially available vacuum laminator. Examples of the commercially available vacuum laminator include a vacuum air-pressed laminator manufactured by Meiki Co., Ltd. and a vacuum applicator manufactured by Nikko-Materials Co., Ltd.

After the laminating of the magnetic sheet 310 and the inner layer substrate 200, the smoothing of the laminated magnetic sheets 310 may be performed, for example, by pressing the thermal pressing member from the support side under normal pressure (under atmospheric pressure). Pressing conditions for the smoothing can be the same as the thermal pressing conditions for the lamination. The smoothing may be performed using a commercially available laminator. Note that the lamination and the smoothing may be successively performed using the above-mentioned commercially available vacuum laminator.

After laminating the magnetic sheet on the inner layer substrate, the resin composition layer is thermally curing to form a magnetic layer. As illustrated in one example in FIG. 10, the resin composition layer 320a laminating to the inner layer substrate 200 is thermally curing to form a first magnetic layer 320.

Although conditions for thermally curing the resin composition layer 320a depend on the composition and kind of the resin composition, curing temperature is preferably 120°C or higher, more preferably 130°C or higher, and still more preferably 150°C or higher, and preferably 240°C or lower, more preferably 220°C or lower, and still more preferably 200°C or lower. Curing time for the resin composition layer 320a is preferably 5 minutes or longer, more preferably 10 minutes or longer, and still more preferably 15 minutes or longer, and preferably 120 minutes or shorter, more preferably 100 minutes or shorter, and still more preferably 90 minutes or shorter.

The support 330 may be removed after the thermally curing of the step (A) and before the step (B), or alternatively may be peeled off after the step (B).

### Step (B)

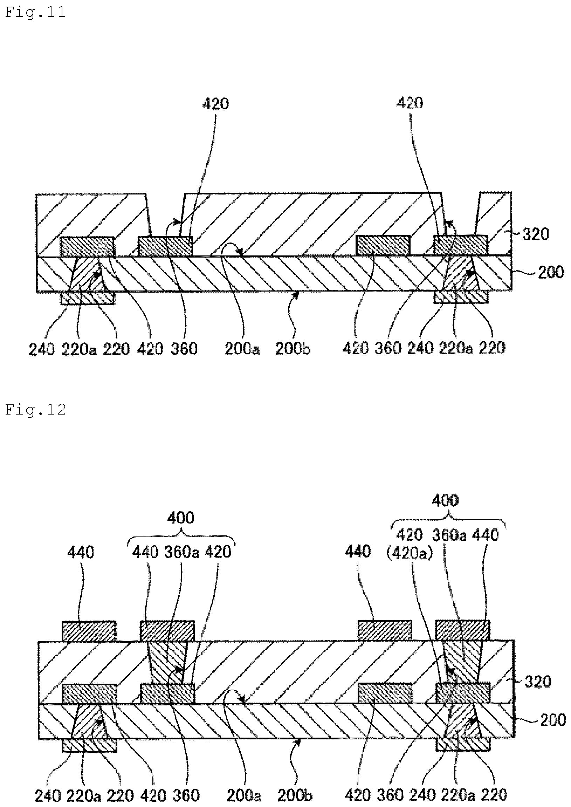

At the step (B), as illustrated in one example in FIG. 11, the first magnetic layer 320 is perforated to form a via hole 360. The via hole 360 functions as a path for electrically connecting the first conductive layer 420 to a later-mentioned second conductive layer 440. In accordance with, for example, the composition of the resin composition used for the formation of the magnetic layer, the via hole 360 may be formed using a drill, laser, plasma, or the like. The size and shape of the hole may be suitably determined in accordance with the design of a printed wiring board.

### Step (C)

At the step (C), a surface of the magnetic layer having the via hole formed therein is polished. A method for the polishing at the step (C) can be the same as that described at the step (3) of the first embodiment.

From the viewpoint of enhancing plating adhesion, the arithmetic mean roughness (Ra) of the polished surface of the magnetic layer is preferably 300 nm or more, more preferably 350 nm or more, and still more preferably 400 nm or more. The upper limit of the arithmetic mean roughness (Ra) is preferably 1000 nm or less, more preferably 900 nm or less, and still more preferably 800 nm or less. The surface roughness (Ra) can be measured using a non-contact type surface roughness meter, for example.

### Step (D)

At the step (D), as illustrated in one example in FIG. 12, the second conductive layer 440 is formed on the first magnetic layer 320.

A conductive material that can constitute the second conductive layer 440 is the same as the material of the conductive layer described at the step (4) of the first embodiment.

From the viewpoint of thinner, the thickness of the second conductive layer 440 is preferably 70 µm or less, more preferably 60 µm or less, still more preferably 50 µm or less, still more preferably 40 µm or less, and particularly preferably 30 µm or less, 20 µm or less, 15 µm or less, or 10 µm or less. The lower limit of the thickness is preferably 1 µm or more, more preferably 3 µm or more, and still more preferably 5 µm or more.

The second conductive layer 440 can be formed by metal plating. The second conductive layer 440 is preferably formed by a wet plating method, such as a semi-additive method and a full-additive method, including, for example, a non-electrolytic plating step, a mask pattern formation step, an electrolytic plating step, and a flash etching step. When the second conductive layer 440 is formed using the wet plating method, the formed second conductive layer 440 can have a desired wiring pattern. Note that, through this step, via-hole wiring 360a is also formed inside the via hole 360.

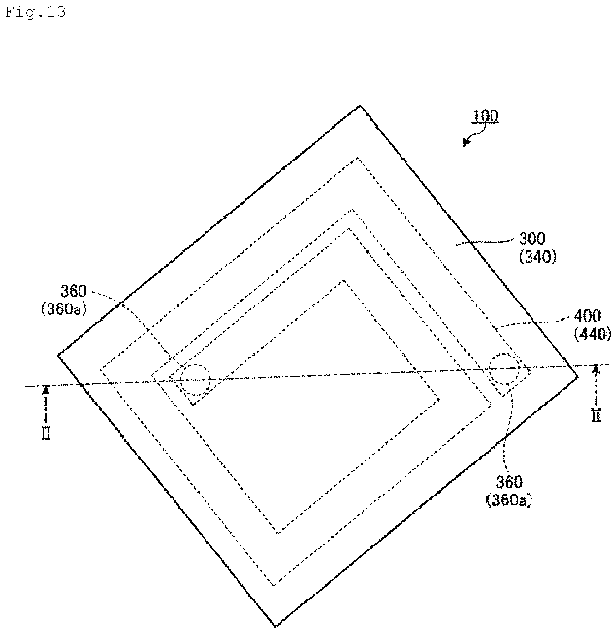

As illustrated in examples in FIG. 13 to FIG. 15, the first conductive layer 420 and the second conductive layer 440 may be spirally provided. In an example, one end, closer to the center, of a spiral wiring part of the second conductive layer 440 is electrically connected to one end, closer to the center, of a spiral wiring part of the first conductive layer 420 via the via-hole wiring 360a. Another end, closer to the outer periphery, of the spiral wiring part of the second conductive layer 440 is electrically connected to a land 420a of the first conductive layer 42 via the via-hole wiring 360a. Thus, the other end, closer to the outer periphery, of the spiral wiring part of the second conductive layer 440 is electrically connected to the external terminal 240 via the via-hole wiring 360a, the land 420a, and the through hole wiring 220a.

The coil-shaped conductive structure 400 includes: the spiral wiring part that is a part of the first conductive layer 420; the spiral wiring part that is a part of the second conductive layer 440; and the via-hole wiring 360a configured to electrically connect the spiral wiring part of the first conductive layer 420 to the spiral wiring part of the second conductive layer 440.

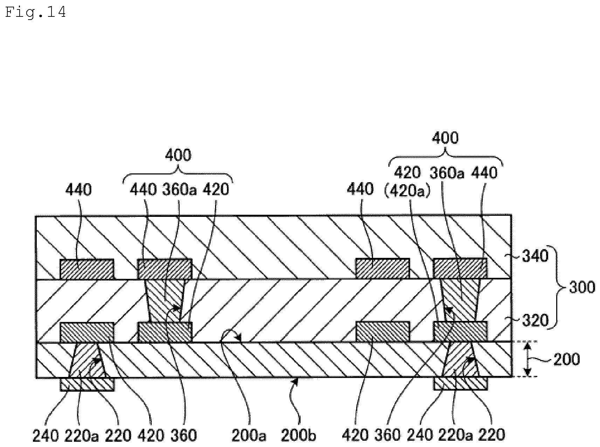

After the step (D), the step of further forming a magnetic layer on the conductive layer may be performed. Specifically, as illustrated in an example in FIG. 14, a second magnetic layer 340 is formed on the first magnetic layer 320 having the second conductive layer 440 and the via-hole wiring 360a formed therein. The second magnetic layer may be formed by the same steps as those already described.

### Inductor component

An inductor component includes the circuit board of the present invention. When including the circuit board obtained by the method of manufacturing the circuit board of the first embodiment, such inductor component has an inductor pattern formed of a conductor in at least a part of the circumference of the cured product of the magnetic paste. As the inductor component, for example, an inductor component described in Japanese Patent Application Laid-open No. 2016-197624 can be applied.

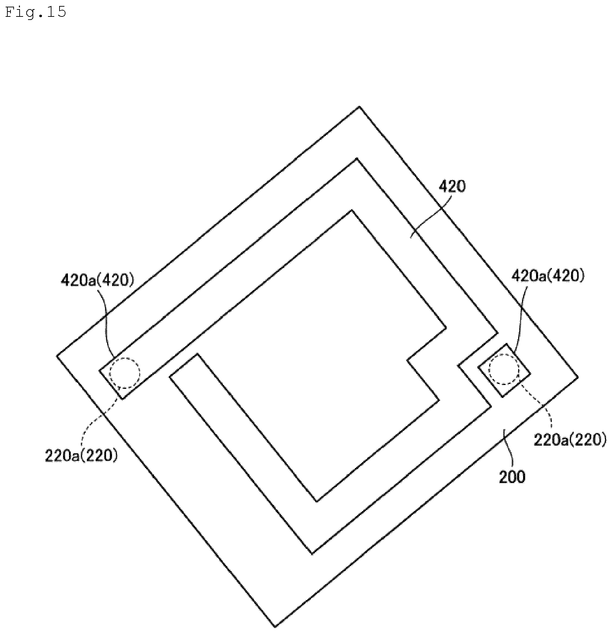

When including the circuit board obtained by the method of manufacturing the circuit board of the second embodiment, an inductor substrate includes: a magnetic layer; and a conductive structure at least a part of which is embedded in the magnetic layer, and the inductor substrate includes an inductor element including the conductive structure and a part of the magnetic layer extending in the thickness direction of the magnetic layer and surrounded by the conductive structure. Here, FIG. 13 is a schematic plan view of the inductor substrate including the inductor element built therein, when seen from one side in the thickness direction of the inductor substrate. FIG. 14 is a schematic diagram of an end cross-section of the inductor substrate, when taken along a dot-and-dash line II-II in FIG. 13. FIG. 15 is a schematic plan view to describe a configuration of the first conductive layer of the inductor substrate.

As illustrated in an example in FIG. 13 and FIG. 14, a circuit board 100 is a build-up wiring board including a plurality of magnetic layers (the first magnetic layer 320 and the second magnetic layer 340) and a plurality of conductive layers (the first conductive layer 420 and the second conductive layer 440), in other words, including a build-up magnetic layer and a build-up conductive layer. The inductor substrate 100 further includes the inner layer substrate 200.

As illustrated in FIG. 14, the first magnetic layer 320 and the second magnetic layer 340 constitute a magnetic part 300 that can be regarded as an integrated magnetic layer. Accordingly, the coil-shaped conductive structure 400 is provided so that at least a part of the coil-shaped conductive structure 400 is embedded in the magnetic part 300. In other words, in the inductor substrate 100 of the present embodiment, the inductor element includes: the coil-shaped conductive structure 400; and a core part that is a part of the magnetic part 300 extending in the thickness direction of the magnetic part 300 and surrounded by the coil-shaped conductive structure 400.

As illustrated in an example in FIG. 15, the first conductive layer 420 includes: a spiral wiring part configured to constitute the coil-shaped conductive structure 400; and the rectangular land 420a electrically connected to the through hole wiring 220a. In the illustrated example, the spiral wiring part includes a linear part, a bent part bent at a right angle, and a detour part detouring around the land 420a. In the illustrated example, the spiral wiring part of the first conductive layer 420 has an approximately rectangular shape as the whole outline and is wound counterclockwise from the center toward the outside.

Similarly, the second conductive layer 440 is formed on the first magnetic layer 320. The second conductive layer 440 includes a spiral wiring part configured to constitute the coil-shaped conductive structure 400. In FIG. 13 or FIG. 14, the spiral wiring part includes a linear part and a bent part bent at a right angle. In FIG. 13 or FIG. 14, the spiral wiring part of the second conductive layer 440 has an approximately rectangular shape as the whole outline and is wound clockwise from the center toward the outside.

Such an inductor component can be used as a wiring board on which an electronic component, such as a semiconductor chip, is to be mounted, or the inductor component can be used as a (multilayer) printed wiring board that uses the wiring board as an inner layer substrate. Alternatively, the inductor component can be used as a chip inductor component obtained by making the wiring board into individual pieces, or can be used as a printed wiring board onto which the chip inductor component is surface-mounted.

Using the wiring board, various types of semiconductor devices can be produced. A semiconductor device including the wiring board can be preferably used for electrical products (for example, a computer, a cellular phone, a digital camera, and a television) and vehicles (for example, a motorcycle, an automobile, a train, a ship, and an airplane).

### Examples

Hereinafter, the present invention will be more specifically described using examples, but the present invention is not limited to these examples. Note that, in the following description, "part(s)" and "%" representing an amount mean "part(s) by mass" and "% by mass", respectively, unless otherwise specified.

### Dispersant pH measurement 1 (glass electrode method)

A pH meter (HM-41X, manufactured by DKK-TOA CORPORATION) to be used for measurement was calibrated at 22°C, using a neutral phosphate standard solution (pH 6.86, manufactured by DKK-TOA CORPORATION), a phthalate standard solution (pH 4.01, manufactured by DKK-TOA CORPORATION), and a borate standard solution (pH 9.18, manufactured by DKK-TOA CORPORATION). Each of the dispersants was added to in small amounts and dissolved in 30% by mass of an ethanol solution prepared using 99.5% by volume of absolute ethanol (manufactured by FUJIFILM Wako Pure Chemical Corporation) and pure water, so that a measurement sample having a dispersant concentration of 0.067 g/mL was produced. The pH of the produced measurement sample was measured at 22°C by a glass electrode method using the pH meter calibrated as described above. The measurement was performed 3 times and the average thereof was taken as a pH of the dispersant.

### Dispersant pH measurement 2 (indicator method)

An acidic dispersant was dissolved in acetone to produce a measurement sample (22°C) having a dispersant concentration of 0.1 g/mL. A pH test paper was dipped gently in the measurement sample, and pulled up to dry excessive moisture. The color of a wet portion of the test paper was compared with a color sample, and a pH represented by the closest color in the color sample to the color of the wet portion was regarded as the pH of the sample.

### Example 1: Preparation of magnetic paste 1

15 parts by mass of an epoxy resin (ZX-1059, a mixed product of a bisphenol A epoxy resin and a bisphenol F epoxy resin, manufactured by NIPPON STEEL Chemical & Material Co., Ltd.), 5 parts by mass of an epoxy resin (ZX-1658GS, cyclic aliphatic diglycidyl ether, manufactured by NIPPON STEEL Chemical & Material Co., Ltd.), 1.1 parts by mass of an acidic dispersant (C-2093I, an acidic dispersant for nanoparticles, manufactured by NOF CORPORATION, pH = 2.9 when measured by the glass electrode method, pH = 2 when measured by the indicator method), 1 part by mass of a curing agent (2MZA-PW, an imidazole-based epoxy resin curing agent, manufactured by SHIKOKU CHEMICALS CORPORATION), and 110 parts by mass of magnetic powder (M05S, Fe-Mn-based ferrite, having an average particle diameter of 3 µm, manufactured by Powdertech Co., Ltd.) were mixed to prepare a magnetic paste 1.

### Example 2: Preparation of magnetic paste 2

A magnetic paste 2 was prepared in the same manner as in Example 1, except that, in Example 1, 5 parts by mass of the epoxy resin (ZX-1658GS, cyclic aliphatic diglycidyl ether, manufactured by NIPPON STEEL Chemical & Material Co., Ltd.) was changed to 5 parts by mass of an epoxy resin (EX-201, resorcinol diglycidyl ether, manufactured by Nagase ChemteX Corporation); and 1.1 parts by mass of the acidic dispersant (C-2093I, an acidic dispersant for nanoparticles, manufactured by NOF CORPORATION, pH = 2.9 when measured by the glass electrode method, pH = 2 when measured by the indicator method) was changed to 1.1 parts by mass of an acidic dispersant (SC-1015F, a polyfunctional comb-shaped functional polymer having a polyoxyalkylene chain, manufactured by NOF CORPORATION, pH = 3.3 when measured by the glass electrode method, pH = 3 when measured by the indicator method).

### Example 3: Preparation of magnetic paste 3

A magnetic paste 3 was prepared in the same manner as in Example 1, except that, in Example 1, the acidic dispersant (C-2093I, an acidic dispersant for nanoparticles, manufactured by NOF CORPORATION, pH = 2.9 when measured by the glass electrode method, pH = 2 when measured by the indicator method) was changed to 1.1 parts by mass of an acidic dispersant (DA-375, polyether phosphate, manufactured by Kusumoto Chemicals, Ltd., pH = 3 when measured by the indicator method, the pH of the acidic dispersant could not be measured by the glass electrode method because the acidic dispersant was insoluble in 30% by mass of an ethanol solution).

### Example 4: Preparation of magnetic paste 4

A magnetic paste 4 was prepared in the same manner as in Example 1, except that, in Example 1, the amount of the acidic dispersant (C-2093I, an acidic dispersant for nanoparticles, manufactured by NOF CORPORATION, pH = 2.9 when measured by the glass electrode method, pH = 2 when measured by the indicator method) was changed from 1.1 parts by mass to 2.2 parts by mass.

### Example 5: Preparation of magnetic paste 5

A magnetic paste 5 was prepared in the same manner as in Example 1, except that,
in Example 1,
1) the amount of the epoxy resin (ZX-1059, a mixed product of a bisphenol A epoxy resin and a bisphenol F epoxy resin, manufactured by NIPPON STEEL Chemical & Material Co., Ltd.) was changed from 15 parts by mass to 18 parts by mass,
2) 5 parts by mass of the epoxy resin (ZX-1658GS, cyclic aliphatic diglycidyl ether, manufactured by NIPPON STEEL Chemical & Material Co., Ltd.) was changed to 2 parts by mass of an epoxy resin (EX-201, resorcinol diglycidyl ether, manufactured by Nagase ChemteX Corporation),
3) the amount of the acidic dispersant (C-2093I, an acidic dispersant for nanoparticles, manufactured by NOF CORPORATION, pH = 2.9 when measured by the glass electrode method, pH = 2 when measured by the indicator method) was changed from 1.1 parts by mass to 0.8 parts by mass, and
4) the amount of the magnetic powder (M05S, Fe-Mn-based ferrite, having an average particle diameter of 3 µm, manufactured by Powdertech Co., Ltd.) was changed from 110 parts by mass to 75 parts by mass.

### Example 6: Preparation of magnetic paste 6

A magnetic paste 6 was prepared in the same manner as in Example 1, except that,
in Example 1,
1) the amount of the epoxy resin (ZX-1059, a mixed product of a bisphenol A epoxy resin and a bisphenol F epoxy resin, manufactured by NIPPON STEEL Chemical & Material Co., Ltd.) was changed from 15 parts by mass to 5 parts by mass,
2) the amount of the epoxy resin (ZX-1658GS, cyclic aliphatic diglycidyl ether, manufactured by NIPPON STEEL Chemical & Material Co., Ltd.) was changed from 5 parts by mass to 10 parts by mass,
3) the amount of the acidic dispersant (C-2093I, an acidic dispersant for nanoparticles, manufactured by NOF CORPORATION, pH = 2.9 when measured by the glass electrode method, pH = 2 when measured by the indicator method) was changed from 1.1 parts by mass to 2.5 parts by mass, and
4) the amount of the magnetic powder (M05S, Fe-Mn-based ferrite, having an average particle diameter of 3 µm, manufactured by Powdertech Co., Ltd.) was changed from 110 parts by mass to 250 parts by mass.

### Example 7: Preparation of magnetic paste 7

A magnetic paste 7 was prepared in the same manner as in Example 4, except that, in Example 4, the amount of the acidic dispersant (C-2093I, an acidic dispersant for nanoparticles, manufactured by NOF CORPORATION, pH = 2.9 when measured by the glass electrode method, pH = 2 when measured by the indicator method) was changed from 2.2 parts by mass to 3 parts by mass; and 110 parts by mass of the magnetic powder (M05S, Fe-Mn-based ferrite, having an average particle diameter of 3 µm, manufactured by Powdertech Co., Ltd.) was changed to 150 parts by mass of magnetic powder (AW2-08 PF3F, a Fe-Cr-Si-based alloy (amorphous), having an average particle diameter of 3.0 µm, manufactured by EPSON ATMIX Corporation).

### Comparative Example 1: Preparation of magnetic paste 8

A magnetic paste 8 was prepared in the same manner as in Example 1, except that, in Example 1, 1.1 parts by mass of the acidic dispersant (C-2093I, an acidic dispersant for nanoparticles, manufactured by NOF CORPORATION, pH = 2.9 when measured by the glass electrode method, pH = 2 when measured by the indicator method) was changed to 1.1 parts by mass of a dispersant (SN-WET 125, a silicone-based surfactant, manufactured by SAN NOPCO LIMITED, pH = 7.5 when measured by the glass electrode method, pH = 7 when measured by the indicator method).

### Comparative Example 2: Preparation of magnetic paste 9

A magnetic paste 9 was prepared in the same manner as in Example 1, except that, in Example 1, 1.1 parts by mass of the acidic dispersant (C-2093I, an acidic dispersant for nanoparticles, manufactured by NOF CORPORATION, pH = 2.9 when measured by a glass electrode method, pH = 2 when measured by an indicator method) was changed to 1.1 parts by mass of a dispersant (SN-WET 980, a silicone-based surfactant, manufactured by SAN NOPCO LIMITED, pH = 9.8 when measured by a glass electrode method, pH = 9 when measured by an indicator method).

### Comparative Example 3: Preparation of magnetic paste 10

A magnetic paste 10 was prepared in the same manner as in Example 1, except that, in Example 1, 1.1 parts by mass of the acidic dispersant (C-2093I, an acidic dispersant for nanoparticles, manufactured by NOF CORPORATION, pH = 2.9 when measured by the glass electrode method, pH = 2 when measured by the indicator method) was changed to 1.1 parts by mass of a dispersant (DOPA-100, a dispersant for silica, manufactured by Kyoeisha Chemical Co., Ltd., pH = 9.9 when measured by the glass electrode method, pH = 11 when measured by the indicator method).

### Comparative Example 4: Preparation of magnetic paste 11

A magnetic paste 11 was prepared in the same manner as in Example 1, except that, in Example 1, 1.1 parts by mass of the acidic dispersant (C-2093I, an acidic dispersant for nanoparticles, manufactured by NOF CORPORATION, pH = 2.9 when measured by the glass electrode method, pH = 2 when measured by the indicator method) was not used.

### Measurement of viscosity of magnetic paste

The temperature of each of the magnetic pastes 1 to 11 was kept at 25°C ± 2°C, and the viscosity thereof at 25°C was measured using an E-type viscometer (RE-80U, manufactured by TOKI SANGYO CO., LTD., 3° × R9.7 cone, 5 rpm). From the viewpoints of printability and easiness of purging air bubbles, the measured viscosity was evaluated on the following criteria.
○: less than 100 Pa·s
Δ: 100 Pa·s or more and less than 200 Pa·s
×: 200 Pa·s or more

### Measurement of viscosity of magnetic paste after a lapse of 1 week

While being kept at 25°C ± 2°C, the magnetic pastes 1 to 11 were allowed to stand for 1 week. The viscosity of each of the magnetic pastes at 25°C was measured using the E-type viscometer(RE-80U, manufactured by TOKI SANGYO CO., LTD., 3° × R9.7 cone, 5 rpm). From the viewpoints of printability and easiness of purging air bubbles, the measured viscosity was evaluated on the following criteria.
○: less than 100 Pa·s
Δ: 100 Pa·s or more and less than 200 Pa·s
×: 200 Pa·s or more

### Measurement of mechanical strength (tensile break strength)

As a support, a polyethylene terephthalate (PET) film (PET501010, manufactured by LINTEC Corporation, 50 µm in thickness) having been subjected to treatment with a silicon-based release agent was prepared. Each of the magnetic pastes 1 to 11 was uniformly applied onto a release surface of the PET film by a doctor blade so as to achieve a paste layer thickness of 100 µm after drying, whereby a magnetic sheet was obtained. The obtained magnetic sheet was heated at 180°C for 90 minutes to heat-cure the paste layer, and the support was detached from the magnetic sheet to obtain a cured product in a sheet form. The obtained sample was subjected to tensile break strength measurement in accordance with JIS K7127. The measurement result was evaluated on the following criteria.
○: 50 MPa or more
Δ: 40 MPa or more and less than 50 MPa
×: less than 40 MPa

### Evaluation of adhesion strength to plating copper

Both surfaces of a double-sided copper clad laminate with an epoxy resin-glass cloth base material (R5715ES, manufactured by Matsushita Electric Works, Ltd., having a copper foil thickness of 18 µm and a substrate thickness of 0.3 mm) were etched to a depth of 1 µm by using a micro-etching agent (CZ8100, manufactured by MEC COMPANY LTD.), whereby the copper surfaces were roughened to prepare an inner layer substrate.

Each of the magnetic pastes 1 to 11 was uniformly applied onto the inner layer substrate by a doctor blade so as to achieve a paste layer thickness of 50 µm after drying, whereby a paste layer was formed. The paste layer was heated at 130°C for 30 minutes and furthermore heated at 145°C for 30 minutes to be thermally cured, whereby a magnetic layer was formed. A surface of the formed magnetic layer was subjected to buffing, and then subjected to heat treatment by heating at 180°C for 30 minutes.

The inner layer substrate in which the surface of the magnetic layer had been subjected to buffing was immersed in a PdCl₂-containing non-electrolytic plating solution at 40°C for 5 minutes, and subsequently immersed in a non-electrolytic copper plating solution at 25°C for 20 minutes. After being subjected to annealing treatment by heating at 150°C for 30 minutes, the inner layer substrate was subjected to copper sulfate electrolytic plating to form a conductive layer having a thickness of 30 µm on the magnetic layer. Next, the inner layer substrate was subjected to annealing treatment at 180°C for 60 minutes. The resulting substrate was used as an evaluation substrate.

A cut having a width of 10 mm and a length of 100 mm was made in the conductive layer of the evaluation substrate, and one end thereof was peeled, and grasped by a grasping tool (an autocom type testing instrument, AC-50C-SL, manufactured by TSE Co., Ltd.), and a load (kgf/cm) at the time of peeling to an extent of 35 mm in a vertical direction at a speed of 50 mm/min at room temperature was measured. The measurement result was evaluated in accordance with the following criteria.
○: 0.2 kgf/cm or more
×: less than 0.2 kgf/cm

### Measurement of relative magnetic permeability and magnetic loss

As a support, a polyethylene terephthalate (PET) film (PET501010, manufactured by LINTEC Corporation, 50 µm in thickness) having been subjected to treatment with a silicone resin-based release agent was prepared. Each of the magnetic pastes 1 to 12 was uniformly applied onto a release surface of the PET film by a doctor blade so as to achieve a paste layer thickness of 100 µm after drying, whereby a magnetic sheet was obtained. The obtained magnetic sheet was heated at 180°C for 90 minutes to thermally cure the paste layer, and the support was detached from the magnetic sheet to obtain a cured product in a sheet form. The obtained cured product was cut into a test piece having a width of 5 mm and a length of 18 mm to obtain an evaluation sample. The relative magnetic permeability (µ') and the magnetic loss (µ") of the evaluation sample were measured at a room temperature of 23°C and a measurement frequency of 100 MHz by a three-turn coil method using HP8362B (manufactured by Agilent Technologies, Ltd).

**Table 1**

| (Table 1) | | | | | | | | | | | | |
|---|---|---|---|---|---|---|---|---|---|---|---|---|
| | | Example | | | | | | | Comparative Example | | | |
| | | 1 | 2 | 3 | 4 | 5 | 6 | 7 | 1 | 2 | 3 | 4 |
| (A) Component | M05S | 110 | 110 | 110 | 110 | 75 | 250 | | 110 | 110 | 110 | 110 |
| | AW2-08PF3F | | | | | | | 150 | | | | |
| (B) Component | ZX-1059 | 15 | 15 | 15 | 15 | 18 | 5 | 15 | 15 | 15 | 15 | 15 |
| | ZX-1658GS | 5 | | 5 | 5 | | 10 | 5 | 5 | 5 | 5 | 5 |
| | EX-201 | | 5 | | | 2 | | | | | | |
| (C) Component | C-2093I | 1.1 | | | 2.2 | 0.8 | 2.5 | 3 | | | | |
| | SC-1015F | | 1.1 | | | | | | | | | |
| | DA-375 | | | 1.1 | | | | | | | | |
| (C) Component | 2MZA-PW | 1 | 1 | 1 | 1 | 1 | 1 | 1 | 1 | 1 | 1 | 1 |
| Others | SN-WET 125 | | | | | | | | 1.1 | | | |
| | SN-WET 980 | | | | | | | | | 1.1 | | |
| | D0PA-100 | | | | | | | | | | 1.1 | |
| Total amount (part by mass) | | 132 1 | 132 1 | 132 1 | 1332 | 968 | 2685 | 174 | 132 1 | 132 1 | 132 1 | 131 |
| Dispersant pH | measured by glass electrode method | 2.9 | 3.3 | unmeasurable | 2.9 | 2.9 | 2.9 | 2.9 | 7.5 | 9.8 | 9.9 | without |
| | meesured by indicator method | 2 | 3 | 3 | 2 | 2 | 2 | 2 | 7 | 9 | 11 | dispersant |
| Viscosity | Evaluation | ○ | ○ | ○ | ○ | ○ | ○ | ○ | ○ | Δ | x | x |
| | Measured value (Pas) | 39 | 53 | 40 | 60 | 55 | 73 | 75 | 70 | 175 | 229 | 210 |
| Viscosity after a lapse of 1 week | Evaluation | ○ | ○ | ○ | ○ | ○ | Δ | Δ | × | Δ | Δ | × |
| | Measured value (Pa·s) | 51 | 88 | 59 | 91 | 72 | 135 | 144 | 221 | 189 | 169 | 252 |
| Mechanical strenght | Evaluation | ○ | ○ | ○ | ○ | ○ | ○ | ○ | × | Δ | ○ | Δ |
| | Measured value (MPa) | 50 | 54 | 50 | 51 | 52 | 52 | 58 | 34 | 48 | 53 | 44 |
| Adhesion strength | Evaluation | ○ | ○ | ○ | ○ | ○ | ○ | ○ | ○ | ○ | ○ | × |
| | Measured value (kgf/cm) | 024 | 027 | 026 | 024 | 025 | 024 | 026 | 023 | 02 | 023 | 0.14 |
| Relative magnetic permeability (100 MHz) | | 5 | 5 | 5 | 5 | 4 | 7 | 6 | 5 | 5 | 5 | 4 |
| Magnetic loss (100 MHz) | | 0.7 | 0.7 | 0.7 | 0.7 | 0.5 | 1.0 | 0.5 | 0.7 | 0.7 | 0.7 | 0.5 |

### Manufacture of circuit board

A double-sided copper clad laminate with an epoxy resin-glass cloth base material (R5715ES, manufactured by Matsushita Electric Works, Ltd., having a copper foil thickness of 18 µm and a substrate thickness of 0.3 mm) was prepared as an inner layer substrate.

Through holes each having a diameter of 0.35 mm were formed at 1-mm pitch in the inner layer substrate, and then, a roughening step was carried out. The roughening step was carried out in such a manner that the internal layer substrate was immersed in a swelling liquid, Swelling Dip Securiganth P, containing diethylene glycol monobutyl ether and manufactured by Atotech Japan K. K., at 60°C for 5 minutes. Subsequently, the internal layer substrate was immersed in a roughening solution, Concentrate Compact P (an aqueous solution of 60 g/L of KMnO₄ and 40 g/L of NaOH), manufactured by Atotech Japan K. K., at 80°C for 10 minutes. After washed with water, the internal layer substrate was finally immersed in a neutralization solution, Reduction Solution Securiganth P, manufactured by Atotech Japan K. K., at 40°C for 5 minutes. After that, the internal layer substrate was dried at 130°C for 15 minutes. Thus, walls of the through holes were roughened and a smear was removed therefrom.

Next, the inner layer substrate was immersed in a PdCl₂-containing non-electrolytic plating solution at 40°C for 5 minutes, and then, immersed in a non-electrolytic copper plating solution at 25°C for 20 minutes. After being subjected to annealing treatment by heating at 150°C for 30 minutes, the inner layer substrate was subjected to copper sulfate electrolytic plating. Next, the inner layer substrate was subjected to annealing treatment at 190°C for 60 minutes to form a plating layer in the through holes, whereby a through hole substrate was obtained.

The magnetic paste 1 produced in Example 1 was printed on the through hole substrate, and the through holes were filled with the magnetic paste 1 to form a paste layer. After the paste layer was formed, the through hole substrate was heated at 130°C for 30 minutes, and further heated at 150°C for 30 minutes.

Next, surfaces of the paste layer and the through hole substrate were subjected to buffing. Furthermore, the through hole substrate was heated at 180°C for 30 minutes to thermally cure the paste layer, whereby a magnetic layer was obtained.

The through hole substrate was immersed in a PdCl₂-containing non-electrolytic plating solution at 40°C for 5 minutes. Subsequently, the through hole substrate was immersed in a non-electrolytic copper plating solution at 25°C for 20 minutes. After being subjected to annealing treatment by heating at 150°C for 30 minutes, the through hole substrate was subjected to copper sulfate electrolytic plating to form a conductive layer having a thickness of 30 µm on the magnetic layer. Next, the through hole substrate was subjected to annealing treatment at 180°C for 60 minutes. Subsequently, an etching resist was formed and patterned by etching to obtain a circuit board.

This circuit board had neither a peeled portion nor a blister at an interface between a surface of the magnetic layer and the conductive layer, and thus was excellent in plating adhesion.

### Reference Signs List

- 10: core substrate
- 11: support substrate
- 12: first metal layer
- 13: second metal layer
- 14: through hole
- 20: plating layer
- 30a: magnetic paste
- 30: magnetic layer
- 40: conductive layer
- 41: pattern conductive layer
- 100: circuit board
- 200: inner layer substrate
- 200a: first main surface
- 200b: second main surface
- 220: through hole
- 220a: through hole wiring
- 240: external terminal
- 300: magnetic part
- 310: magnetic sheet
- 320a: resin composition layer
- 320: first insulating layer
- 330: support
- 340: second insulating layer
- 360: via hole
- 360a: via-hole wiring
- 400: coil-shaped conductive structure
- 420: first conductive layer
- 420a: land
- 440: second conductive layer

## Claims

1. A magnetic paste, comprising:
magnetic powder (A);
an epoxy resin (B);
an acidic dispersant (C); and
a curing agent (D).

2. The magnetic paste according to claim 1, wherein the acidic dispersant (C) has a pH of less than 4.

3. The magnetic paste according to claim 1 or 2, wherein the acidic dispersant (C) has a pH of 2 or more.

4. The magnetic paste according to any one of claims 1 to 3, wherein a content of the acidic dispersant (C) is 0.1% by mass or higher and 5% by mass or lower, with respect to 100% by mass of non-volatile components in the magnetic paste.

5. The magnetic paste according to any one of claims 1 to 4, wherein the curing agent (D) includes an imidazole-based epoxy resin curing agent.

6. The magnetic paste according to any one of claims 1 to 5, wherein the magnetic powder (A) is at least one selected from iron oxide powder and iron alloy-based metal powder.

7. The magnetic paste according to any one of claims 1 to 6, wherein
the magnetic powder (A) includes iron oxide powder,
and
the iron oxide powder includes ferrite containing at least one selected from Ni, Cu, Mn, and Zn.

8. The magnetic paste according to any one of claims 1 to 7, wherein the magnetic powder (A) includes iron alloy-based metal powder containing at least one selected from Si, Cr, Al, Ni, and Co.

9. The magnetic paste according to any one of claims 1 to 8, wherein a content of the magnetic powder (A) is 70% by mass or higher and 98% by mass or lower, with respect to 100% by mass of non-volatile components in the magnetic paste.

10. The magnetic paste according to any one of claims 1 to 9, the magnetic paste is for through hole filling.

11. A cured product of the magnetic paste according to any one of claims 1 to 10.

12. A circuit board, comprising:
a substrate having a through hole; and
a cured product of the magnetic paste according to any one of claims 1 to 10, the magnetic paste being filled in the through hole.

13. An inductor component, comprising the circuit board according to claim 12.
